# EUROPEAN PATENT SPECIFICATION

(11) **EP 2 299 477 B1**
(45) Date of publication and mention of the grant of the patent: **28.08.2013**
(21) Application number: 09758348.8
(22) Date of filing: 03.06.2009
(51) Int. Cl.: H01L 31/18, H01L 21/677, C23C 16/54, C23C 16/458

(54) **Thin- film solar cell manufacturing apparatus**
Dünnfilm-Solarzellenherstellungsvorrichtung
Appareil de fabrication d'une cellule solaire à couche mince

(30) Priority: 06.06.2008 JP 2008149933
(43) Date of publication of application: 23.03.2011
(73) Proprietor: Ulvac, Inc., Chigasaki-shi Kanagawa 253-8543 (JP)
(72) Inventor: SHIMIZU Yasuo, Chigasaki-shi Kanagawa 253-8543 (JP); OGATA Hideyuki, Chigasaki-shi Kanagawa 253-8543 (JP); MATSUMOTO Koichi, Chigasaki-shi Kanagawa 253-8543 (JP); NOGUCHI Takafumi, Chigasaki-shi Kanagawa 253-8543 (JP); WAKAMORI Jouji, Chigasaki-shi Kanagawa 253-8543 (JP); OKAYAMA Satohiro, Chigasaki-shi Kanagawa 253-8543 (JP); MORIOKA Yawara, Chigasaki-shi Kanagawa 253-8543 (JP); SUGIYAMA Noriyasu, Chigasaki-shi Kanagawa 253-8543 (JP); SHIGETA Takashi, Chigasaki-shi Kanagawa 253-8543 (JP); KURIHARA Hiroyuki, Chigasaki-shi Kanagawa 253-8543 (JP); SAITO Kazuya, Chiba 289-1226 (JP)
(74) Representative: Eisenführ, Speiser & Partner
(86) International application number: PCT/JP2009/060154
(87) International publication number: WO 2009/148081

(56) References cited:
- EP-A1- 1 359 611
- EP-A1- 1 622 192
- JP-A- 8 236 795
- JP-A- 2001 118 907
- JP-A- 2002 083 774
- JP-A- 2004 349 475
- JP-A- 2005 139 524
- JP-A- 2006 054 284
- JP-A- 2007 288 036
- US-A1- 2001 007 246

## Description

### TECHNICAL FIELD

The present invention relates to a thin-film solar cell manufacturing apparatus.

### BACKGROUND ART

Most current solar cells are a single crystal Si type solar cell and a polycrystal Si type solar cell. However, due to material shortages of Si or the like, demand has recently been increasing for thin-film solar cells formed with a thin-film Si-layer in which manufacturing costs are low and the risk of material shortages is low. Moreover, in addition to conventional thin-film solar cell with only an a-Si (amorphous silicon) layer, a demand for tandem-type thin-film solar cells has recently been increasing, in which the conversion efficiency of the tandem-type thin-film solar cells is improved by laminating an a-Si-layer and a µc-Si (microcrystalline silicon) layer.

A plasma-CVD apparatus is often used for forming a thin-film Si-layer (semiconductor layer) for the thin-film solar cell. As such a plasma-CVD apparatus, for example a single-wafer-type PE-CVD (plasma CVD) apparatus, an in-line type PE-CVD apparatus, a batch-type PE-CVD apparatus, and the like exist.

Here, when the conversion efficiency of a thin-film solar cell is taken into consideration, the µc-Si layer of the tandem-type solar cell needs to be formed with a film thickness (about 1.5 µm) of approximately five times larger than that of the a-Si layer. Additionally, since the µc-Si layer needs to uniformly form a good microcrystalline layer, there is a limit on increasing a film formation rate. Accordingly, there is a need to increase the number of batch processing to improve productivity. That is, an apparatus which can realize higher throughput at a lower film formation rate is needed.

Additionally, a CVD apparatus which can form a high-quality thin film and can lower manufacturing costs or maintenance costs is proposed in Patent Literature 1. For example, the CVD apparatus of Patent Literature 1 includes a substrate (base) delivery-dispensing apparatus, a film forming chamber group which can store a plurality of substrates, a transfer chamber, and a chamber transfer apparatus. A shutter with airtightness is provided at an inlet and outlet port of a film forming room of a film forming chamber, and an inlet and outlet port of a storage chamber of the transfer chamber is always open. Also, when forming a Si-layer on a substrate, the transfer chamber is transferred to a position of the substrate delivery-dispensing apparatus by the chamber transfer apparatus, and a substrate carrier is transferred to the transfer chamber side. Additionally, the transfer chamber and the film forming chamber are joined together by the chamber transfer apparatus, the substrate carrier is transferred to the film forming chamber, and a Si layer is formed on the substrate.

### [Patent Literature]

[Patent Literature 1] Japanese Patent Application, First Publication No. 2005-139524
The publication EP 1359611 A1, describes a method and an apparatus for plasma CVD, comprising a load lock chamber and a heating chamber and a cooling chamber.

### DISCLOSURE OF THE INVENTION

### [Problems to be Solved by the Invention]

Meanwhile, in the CVD apparatus of Patent Literature 1, in order to form a thin-film Si-layer on a substrate, the transfer chamber is joined to the film forming chamber, the shutter of the film forming chamber is opened after the inside of the transfer chamber is brought into a vacuum state, and the substrate carrier is transferred to the film forming chamber from the transfer chamber. Thereafter, the substrate is heated within the film forming chamber, and a thin-film Si-layer is formed on the substrate by a plasma CVD method. After the film forming of the thin-film Si-layer is ended, the substrate is cooled, and the substrate is conveyed to the other processing chambers. Accordingly, although Si-layers can be simultaneously formed on a plurality of substrates, in order to form a thin-film Si-layer on a substrate, a number of other steps are required besides the film forming step to the substrate. Additionally, in order to realize a high throughput, it is necessary to increase the installation number of CVD apparatuses. However, when the effects of the apparatuses on the installation area and the cost are taken into consideration, there is a limit on increasing the installation number of the CVD apparatuses.
Additionally, a heater is provided in the transfer chamber in the Patent Literature 1, and a substrate is heated to a predetermined temperature in advance before being moved to the film forming chamber. That is, a heater function is provided in both the transfer chamber and the film forming chamber. Thereby, there are a problems in that the apparatus becomes expensive, and the energy consumed when a film is formed becomes large.

The object of the present invention is to provide a thin-film solar cell manufacturing apparatus which can reduce consumption energy, and can realize high productivity, low manufacturing cost, and high throughput.

### [Means for Solving the Problem]

A thin-film solar cell manufacturing apparatus related to a first aspect of the present invention includes: a film forming chamber that is evacuated to a reduced pressure and forms a film on a substrate using a CVD method, a loading-ejecting chamber that is connected to the film forming chamber via a first opening-closing part and that is switchable between atmospheric pressure and reduced pressure, a first carrier that holds a pre-processed substrate, and a second carrier that holds a post-processed substrate, wherein the first carrier and the second carrier hold the substrate in a vertical posture where a surface to be film-formed of the substrate is parallel to a direction of gravitational force; the loading-ejecting chamber simultaneously stores a plurality of the first carriers and a plurality of the second carriers in a state where the internal pressure of the loading-ejecting chamber is reduced; the first carriers and the second carriers are alternately arranged in parallel in the loading ejecting chamber; and the first carriers and the second carriers are movable in a direction substantially perpendicular to a moving direction toward the film forming chamber within the loading-ejecting chamber, according to claim 1.
The first carrier and the second carrier may hold a plurality of the substrates so that the substrates are parallel to each other and face each other.
The loading-ejecting chamber may have a carrier transfer mechanism which collectively transfers a plurality of the second carriers to the loading-ejecting chamber from the film forming chamber.
The carrier transfer mechanism may collectively transfer a plurality of the first carriers to the film forming chamber from the loading-ejecting chamber.
The thin-film solar cell manufacturing apparatus may further include a plurality of process modules in which one film forming chamber is connected to one loading-ejecting chamber, and the plurality of process modules is arranged in parallel.
A plurality of the film forming chambers may be connected to one loading-ejecting chamber.

According to the above aspect, since the pre-processed substrate and the post-processed substrate can be simultaneously stored in the loading-ejecting chamber, the evacuation process of the loading-ejecting chamber can be reduced by half. Accordingly, productivity can be markedly improved. Additionally, when the post-processed substrate and the pre-processed substrate are simultaneously stored in the loading-ejecting chamber, the heat accumulated in the post-processed substrate is transferred to the pre-processed substrate, whereby heat exchange is performed. That is, a heating process which is usually performed after storing the pre-processed substrate in the film forming chamber, and a cooling process which is usually performed before carrying the post-processed substrate out of the loading-ejecting chamber can be omitted.
As a result, the heating process and the cooling process become unnecessary, productivity can be improved, and the conventional devices used for the heating process and the cooling process can be reduced. Therefore, space saving and lower cost can be simultaneously achieved.

According to the above aspect, the first carrier and the second carrier are adjacent to each other when being simultaneously stored in the loading-ejecting chamber. Therefore, the heat accumulated in the post-processed substrate held by the second carrier is efficiently transferred to the pre-processed substrate held by the first carrier, so that heat exchange can be performed reliably.

According to the above aspect, a conveyance passage along which a substrate is carried into and carried out of the loading-ejecting chamber can be fixed. Accordingly, the size of the apparatus itself can be kept down, and the installation space of the apparatus can be reduced.

According to the above aspect, the area required for a substrate to move within the apparatus can be reduced. Thus, the apparatus can be miniaturized, and a larger number of apparatuses can be arranged in the same installation area as in the conventional technique. Accordingly, the number of substrates on which films can be simultaneously formed can be increased, and productivity can be improved. Additionally, when a film is formed on a substrate in a state where the substrate is erected in the vertical direction, particles generated when forming a film can be kept from depositing on the film formation face of the substrate. Accordingly, a high-quality semiconductor layer can be formed on the substrate.

According to the above aspect, since films can be simultaneously formed on a plurality of substrates in one carrier, productivity can be further improved.

According to the above aspect, the number of substrates on which films can be simultaneously formed can be further increased by arranging a plurality of process modules in parallel. Therefore, even when a film is formed on a substrate at a low rate, high throughput can be realized. Additionally, the installation time (building time of a manufacturing line) of the apparatus when the manufacturing line is built in a factory or the like can be shortened by integrating the apparatus as the process module. Moreover, when maintenance of the film forming chamber is performed, it becomes unnecessary to stop the whole manufacturing line by performing maintenance for every process module. Accordingly, a decrease in production efficiency during maintenance can be suppressed to a minimum.

According to the above aspect, a substrate attached to a carrier can be moved within the loading-ejecting chamber. Therefore, different film forming materials can be supplied in the film forming chambers respectively, and a plurality of layers with different film forming materials can be more efficiently formed on a substrate.

### [Effects of the Invention]

According to the aspect of the present invention, since the pre-processed substrate and the psot-processed substrate can be simultaneously stored in the loading-ejecting chamber, the evacuation process of the loading-ejecting chamber can be reduced by half. Accordingly, productivity can be markedly improved. Additionally, in such a case, the post-processed substrate and the pre-process substrate are simultaneously stored in the loading-ejecting chamber in a state where the substrates face each other. Thereby, the heat accumulated in the post-processed substrate is transferred to the pre-processed substrate, whereby heat exchange is positively performed. That is, a heating process which is usually performed after the pre-processed substrate is stored in the film forming chamber, and a cooling process which is usually performed before the post-processed substrate is carried out of the loading-ejecting chamber can be omitted. As a result, the heating process and the cooling process become unnecessary, productivity can be improved, and the conventional devices used for the heating process and the cooling process can be reduced. Therefore, space saving and lower cost can be achieved simultaneously.

### BRIEF DESCRIPTION OF THE DRAWINGS

FIG. 1 is a schematic sectional view of a thin-film solar cell related to an embodiment of the present invention.
FIG. 2 is a schematic configuration view of a thin-film solar cell manufacturing apparatus related to an embodiment of the present invention.
FIG. 3A is a perspective view of a film forming chamber related to an embodiment of the present invention.
FIG. 3B is a perspective view of the film forming chamber related to an embodiment of the present invention when seeing from a different angle.
FIG. 3C is a side view of the film forming chamber related to an embodiment of the present invention.
FIG 4A is a perspective view of an electrode unit related to an embodiment of the present invention.
FIG. 4B is a perspective view of the electrode unit related to an embodiment of the present invention when seeing from a different angle.
FIG. 4C is a partial perspective view of the electrode unit related to an embodiment of the present invention.
FIG. 4D is a partial sectional view of a cathode unit and anode unit of the electrode unit related to an embodiment of the present invention.
FIG. 5A is a perspective view of a loading-ejecting chamber related to an embodiment of the present invention.
FIG. 5B is a perspective view of the loading-ejecting chamber related to an embodiment of the present invention when seeing from a different angle.
FIG. 6 is a schematic configuration view of a push-pull mechanism related to an embodiment of the present invention.
FIG. 7A is a perspective view of a schematic configuration of a substrate replacement chamber related to an embodiment of the present invention.
FIG. 7B is a front view of the schematic configuration of the substrate replacement chamber related to an embodiment of the present invention.
FIG. 8 is a perspective view of a substrate storage holder related to an embodiment of the present invention.
FIG. 9 is a perspective view of a carrier related to an embodiment of the present invention.
FIG. 10 is an explanatory view (1) showing a process of a manufacturing method of a thin-film solar cell related to an embodiment of the present invention.
FIG. 11 is an explanatory view (2) showing a process of a manufacturing method of a thin-film solar cell related to an embodiment of the present invention.
FIG. 12 is an explanatory view (3) showing a process of a manufacturing method of a thin-film solar cell related to an embodiment of the present invention.
FIG. 13 is an explanatory view (4) showing a process of a manufacturing method of a thin-film solar cell related to an embodiment of the present invention.
FIG. 14 is an explanatory view (5) showing a process of a manufacturing method of a thin-film solar cell related to an embodiment of the present invention.
FIG. 15A is an explanatory view (1) showing the operation of a push-pull mechanism related to an embodiment of the present invention.
FIG. 15B is an explanatory view (2) showing the operation of the push-pull mechanism related to an embodiment of the present invention.
FIG. 16 is an explanatory view (6) showing a process of a manufacturing method of a thin-film solar cell related to an embodiment of the present invention.
FIG. 17 is an explanatory view (7) showing a process of a manufacturing method of a thin-film solar cell related to an embodiment of the present invention.
FIG. 18 is an explanatory view (8) showing a process of the manufacturing method of a thin-film solar cell related to an embodiment of the present invention, and showing a schematic section when substrates are inserted into the electrode unit.
FIG. 19 is an explanatory view (9) showing a process of a manufacturing method of a thin-film solar cell related to an embodiment of the present invention.
FIG. 20 is an explanatory view (10) showing a process of a manufacturing method of a thin-film solar cell related to an embodiment of the present invention.
FIG. 21 is an explanatory view (11) showing a process of the manufacturing method of a thin-film solar cell related to an embodiment of the present invention, and showing a partial section when substrates are set in the electrode unit.
FIG 22 is an explanatory view (12) showing a process of a manufacturing method of a thin-film solar cell related to an embodiment of the present invention.
FIG 23 is an explanatory view (13) showing a process of a manufacturing method of a thin-film solar cell related to an embodiment of the present invention.
FIG. 24 is an explanatory view (14) showing a process of a manufacturing method of a thin-film solar cell related to an embodiment of the present invention.
FIG 25 is an explanatory view (15) showing a process of a manufacturing method of a thin-film solar cell related to an embodiment of the present invention.
FIG. 26 is a schematic configuration view showing another aspect of the thin-film solar cell manufacturing apparatus related to an embodiment of the present invention.
FIG. 27 is a schematic configuration view showing another arrangement method of the thin-film solar cell manufacturing apparatus related to an embodiment of the present invention.
FIG. 28 is a schematic configuration view showing still another arrangement method of the thin-film solar cell manufacturing apparatus related to an embodiment of the present invention.

### BEST MODES FOR CARRYING OUT THE INVENTION

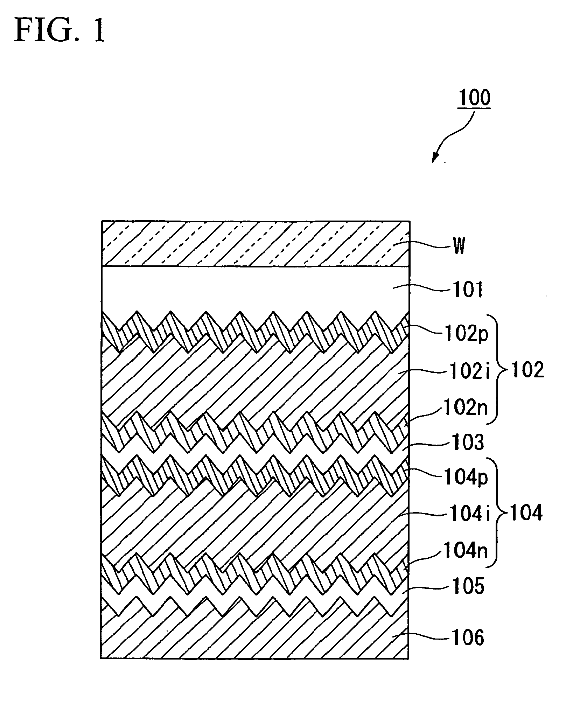

A thin-film solar cell manufacturing apparatus related to an embodiment of the present invention will be described below with reference to FIGS. 1 to 28.

### <Thin-film Solar Cell>

FIG. 1 is a schematic sectional view of a thin-film solar cell. As shown in FIG. 1, in a thin-film solar cell 100, a substrate W which constitutes the surface of the thin-film solar cell 100, a top electrode 101 made of a transparent-electroconductive film, a top cell 102 made of amorphous silicon, an intermediate electrode 103 made of a transparent-electroconductive film, a bottom cell 104 made of microcrystalline silicon, a buffer layer 105 made of a transparent-electroconductive film, and a back electrode 106 made of a metal film are laminated in the top-bottom order (from the top to the bottom) of the drawing. Among these, the top electrode 101 is laminated on the substrate W. The intermediate electrode 103 is laminated between the top cell 102 and the bottom cell 104. That is, the thin-film solar cell 100 is an a-Si/microcrystal Si tandem-type solar cell. In the thin-film solar cell 100 of such tandem structure, power generation efficiency can be improved by absorbing short-wavelength light by the top cell 102 and absorbing long-wavelength light by the bottom cell 104.

The top cell 102 has a three-layer structure configured by laminating a p-layer 102p, an i-layer 102i, and an n-layer 102n in the top-bottom order in the drawing. The three-layer structure of the p-layer 102p, i-layer 102i, and n-layer 102n of the top cell 102 is formed from amorphous silicon. Additionally, the bottom cell 104 has a three-layer structure configured by laminating a p-layer 104p, an i-layer 104i, and an n-layer 104n in the top-bottom order in the drawing. The three-layer structure of the p-layer 104p, i-layer 104i, and n-layer 104n of the bottom cell 104 is made of microcrystalline silicon.

In the thin-film solar cell 100 configured in the above way, when an energy particle called a photon in sunlight strikes the i-layer, an electron and a hole are generated by a photovoltaic effect, the electron moves toward the n-layer and the hole moves toward the p-layer. Light energy can be converted into electrical energy by taking out the electron generated by the photovoltaic effect by the top electrode 101 and the back electrode 106.

Additionally, the intermediate electrode 103 is provided between the top cell 102 and the bottom cell 104, whereby a part of the light which passes through the top cell 102 and reaches the bottom cell 104 is reflected by the intermediate electrode 103 and incident on the top cell 102 again. Accordingly, the sensitivity characteristics of the cell are improved, and the power generation efficiency can be improved.

Additionally, the sunlight incident from the glass substrate W side passes through the respective layers, and is reflected by the back electrode 106. In order to improve the conversion efficiency of light energy, the thin-film solar cell 100 employs a texture structure which aims to achieve a prismatic effect which extends the optical path of the sunlight which incident on the top electrode 101, and the confinement effect of light.

### <THIN-FILM SOLAR CELL MANUFACTURING APPARATUS>

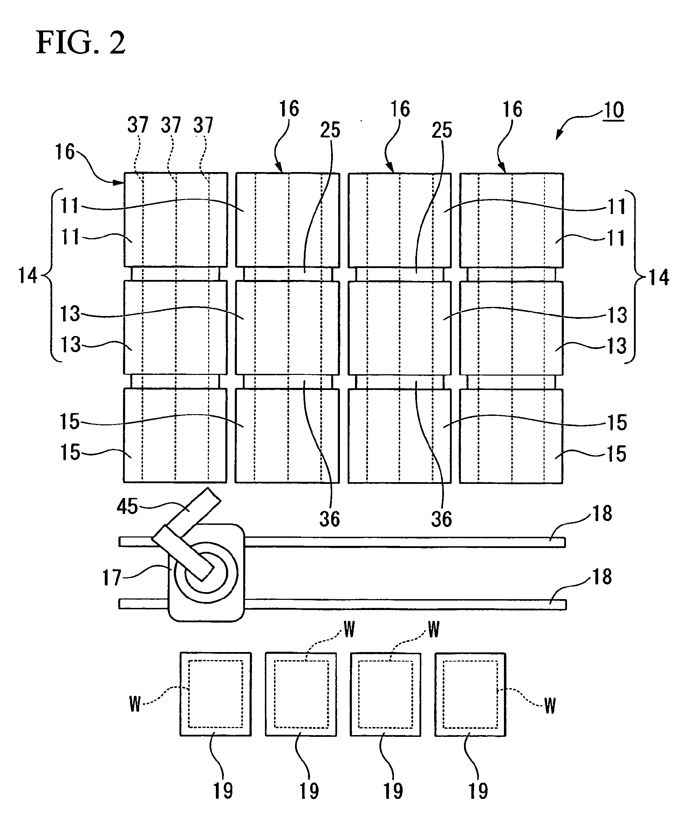

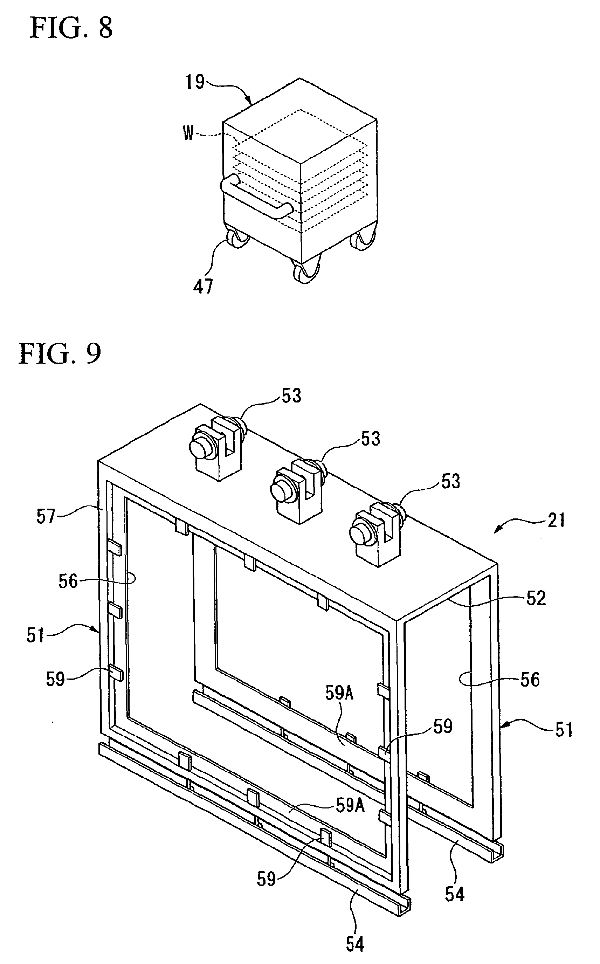

FIG. 2 is a schematic configuration view of a thin-film solar cell manufacturing apparatus. As shown in FIG. 2, the thin-film solar cell manufacturing apparatus 10 includes film forming chambers 11 (first chamber), loading-ejecting chambers 13 (second chamber) which can store substrates W, substrate replacement chambers 15 where the substrates W are attached to and detached from a carrier 21 (refer to FIG. 9), a substrate replacement robot (drive mechanism) 17 for attaching and detaching the substrates W to or from the carrier 21, and substrate storage holders (conveying mechanisms) 19 which store the substrates W. The film forming chambers 11 can simultaneously form bottom cells 104 (semiconductor layers) made of microcrystalline silicon on a plurality of substrates W, using a CVD method. The loading-ejecting chambers 13 can simultaneously store pre-processed substrates W1 which are to be transported into the film forming chambers 11 and post-processed substrates W2 which are transported from the film forming chambers 11. The substrate replacement chambers 15 can attach and detach the pre-processed substrates W1 and the post-processed substrates W2. The substrate storage holders 19 store the substrates W in order to convey the substrates W to the other processing processes. In addition, the film forming chamber 11, the loading-ejecting chamber 13, and the substrate replacement chamber 15 constitute a substrate film formation line 16. In the present embodiment, four substrate film formation lines 16 each including the film forming chamber 11, the loading-ejecting chamber 13, and the substrate replacement chamber 15 are provided. Additionally, the substrate replacement robot 17 can move on rails 18 laid on a floor surface. Accordingly, transfer of the substrates W to all the substrate film formation lines 16 can be performed by one substrate replacement robot 17. Moreover, a process module 14 constituted by the film forming chamber 11 and the loading-ejecting chamber 13 are integrated together, and are formed with a size such that the module can be loaded into an autotruck.

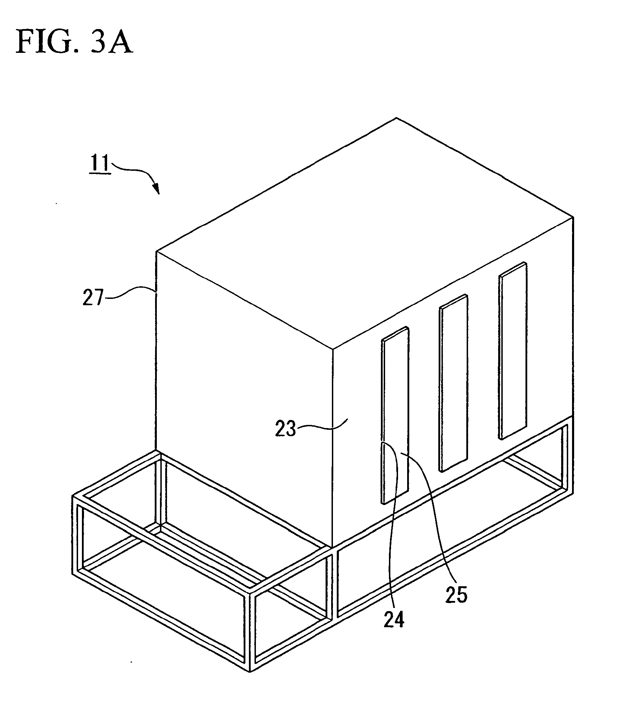

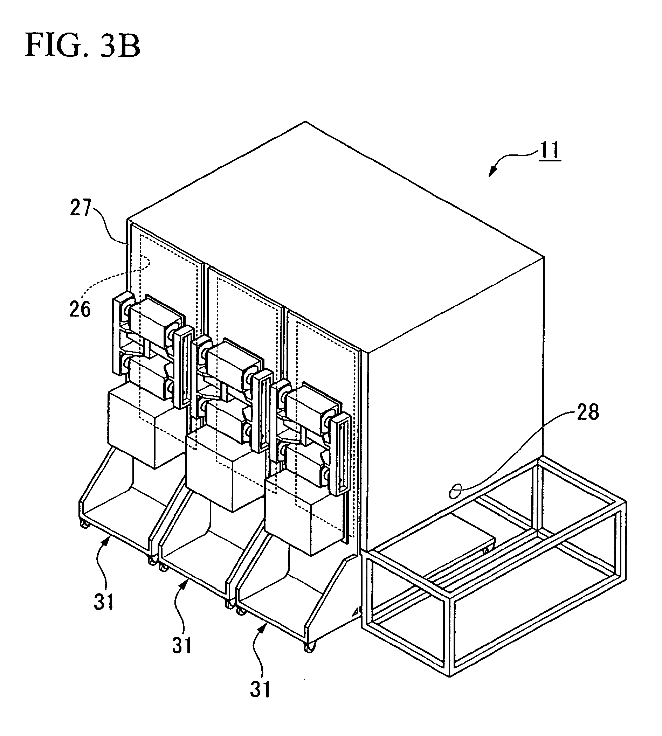

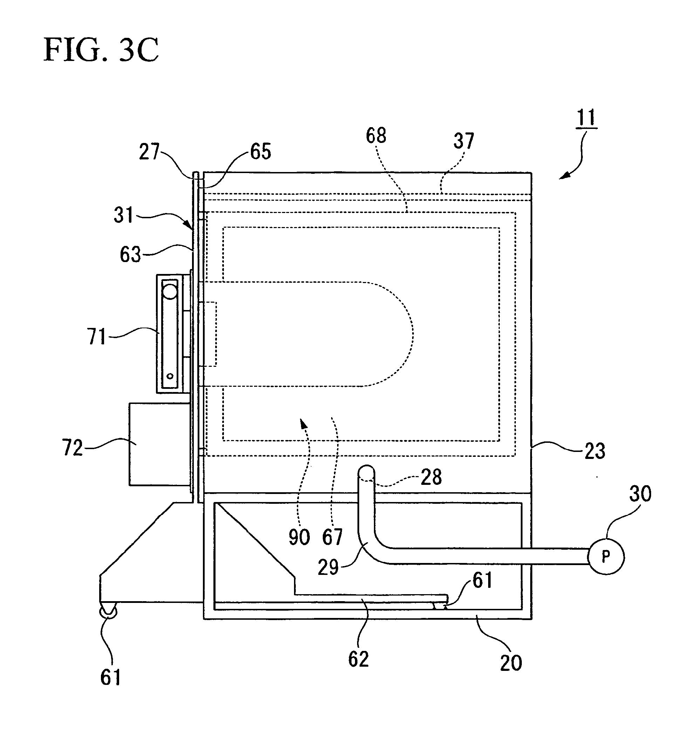

FIGS. 3A to 3C are views showing a schematic configuration of the film forming chamber 11. Among these drawings, FIG. 3A is a perspective view of the film forming chamber 11, FIG. 3B is a perspective view as observed from an angle different from FIG. 3A, and FIG. 3C is a side view of the film forming chamber 11. As shown in FIGS. 3A to 3C, the film forming chamber 11 is formed in a box shape. The film forming chamber 11 has a side surface 23 which is connected to the loading-ejecting chamber 13. Three carrier transfer inlet and outlet ports 24 to which the carrier 21 mounted with the substrates W can pass through are formed in the side surface 23. Additionally, shutters (first opening-closing parts) 25 which open and close the carrier transfer inlet and outlet ports 24 are provided at the carrier transfer inlet and outlet ports 24. When a shutter 25 is closed, the carrier transfer inlet and outlet port 24 is closed while securing airtightness. Three sets of electrode units 31 for forming films on the substrates W are attached to a side surface 27 which is opposite to the side surface 23 of the film forming chamber 11. The electrode units 31 are configured to be attachable to and detachable from the film forming chamber 11. Specifically, as shown in FIG. 3B, three openings 26 are formed at the side surface 27 of the film forming chamber 11, and the electrode units 31 are installed so as to be attachable to and detachable from the openings 26. Additionally, a vacuuming pipe 29 for evacuating the space within the film forming chamber 11 is connected to a lateral lower portion 28 of the film forming chamber 11, and a vacuum pump 30 is provided at the vacuuming pipe 29.

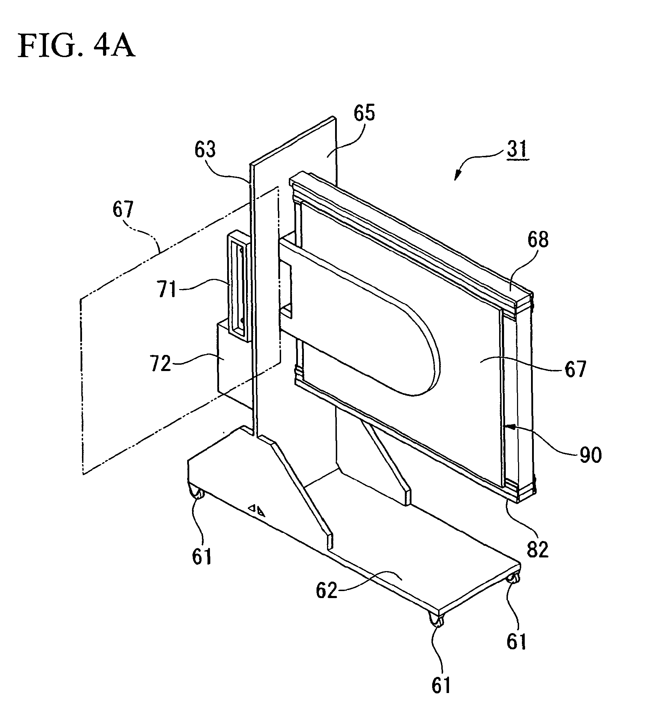

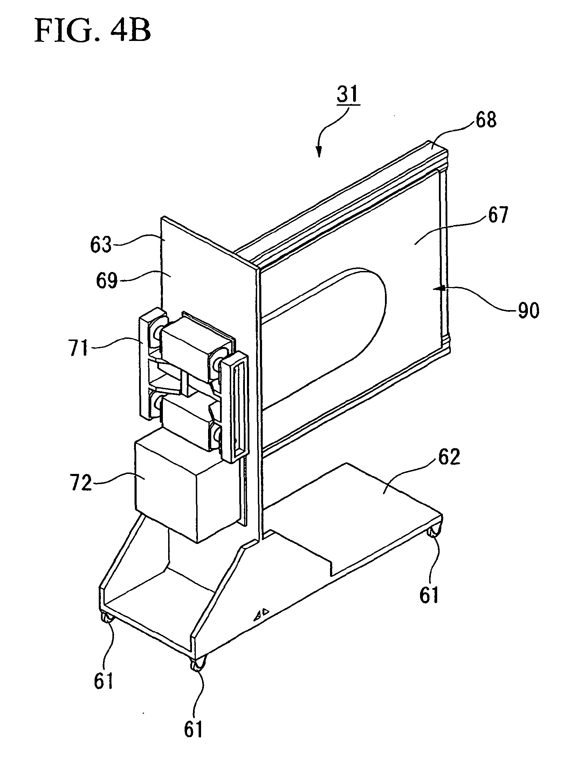

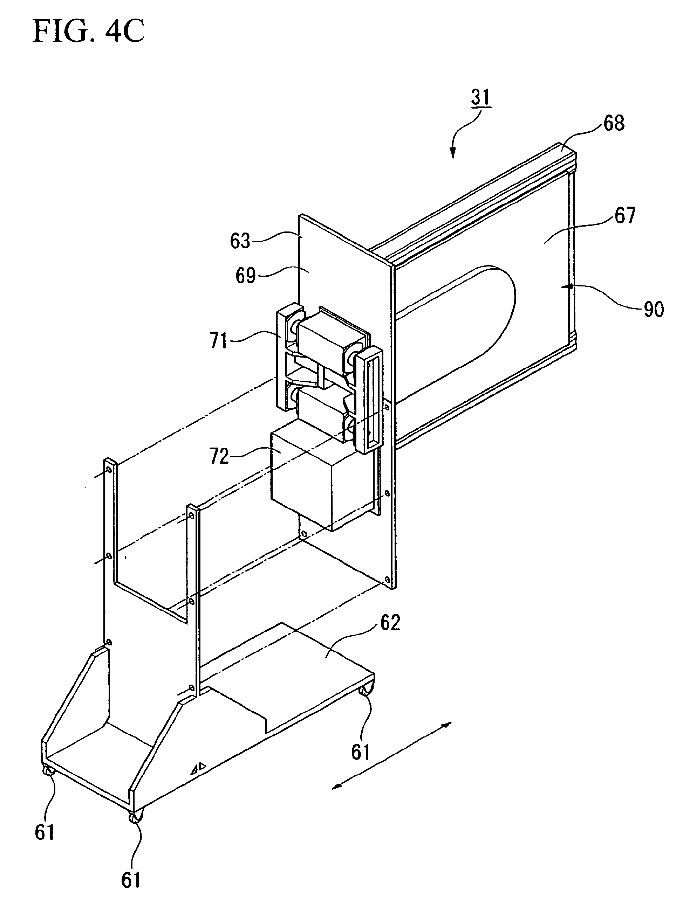

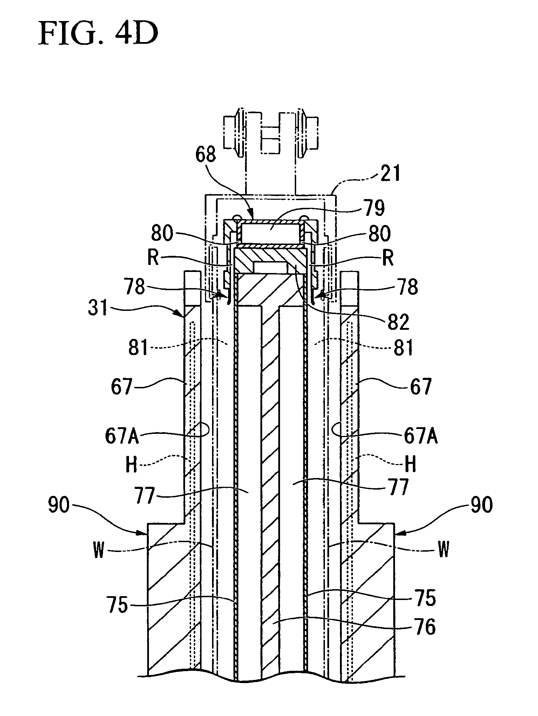

FIGS. 4A to 4D are views showing a schematic configuration of the electrode unit 31. Among these drawings, FIG. 4A is a perspective view of the electrode unit 31, FIG. 4B is a perspective view as observed from a different angle from FIG. 4A, FIG. 4C is a partially exploded perspective view of the electrode unit 31, and FIG. 4D is a partial sectional view of cathode unit and an anode unit. As shown in FIGS. 4A to 4D, wheels 61 are provided at a lower portion of the electrode unit 31, and the electrode unit 31 can be movable on the floor surface by the wheels 61. Additionally, on a bottom plate portion 62 to which the wheels 61 are attached, a side plate portion 63 is erected in the vertical direction. The side plate portion 63 has a size such that the side plate portion blocks the opening 26 of the side surface 27 of the film forming chamber 11.
As shown in FIG. 4C, the bottom plate portion 62 with the wheels 61 may be a truck structure which can be separated from and connected to the electrode unit 31. By adopting such a separable truck structure, the truck is separated after the electrode unit 31 is connected to the film forming chamber 11, and the separated truck can be used for the transfer of other electrode units 31 as a common truck.

That is, the side plate portion 63 forms a part of a wall surface of the film forming chamber 11. An anode unit 90 and a cathode unit 68 which are arranged on both sides of the substrate W when forming a film are formed at a first surface 65 (surface which faces the inside of the film forming chamber 11) of the side plate portion 63. In the electrode unit 31 of the present embodiment, anode units 90 are respectively arranged on both sides of the cathode unit 68 so as to separate from each other so that films can be simultaneously formed on two substrates W by one electrode unit 31. Accordingly, substrates W are respectively on both sides of the cathode unit 68 so as to face each other in a state where the substrates are substantially parallel to the direction of gravitational force, and two anode units 90 are arranged outside the respective substrates W in the thickness direction in a state where the anode units face the substrates W, respectively. In addition, the anode unit 90 is constituted by a plate-shaped anode 67, and a heater H built in the anode unit 90.

Additionally, a drive device 71 for driving the anode units 90, and a matching box 72 for feeding electric power to the cathode intermediate member 76 of the cathode unit 68 when forming a film are attached to the second surface 69 of the side plate portion 63. Moreover, a connecting portion (not shown) for piping which supplies the film forming gas to the cathode unit 68 is formed at the side plate portion 63.

A heater H is built in each anode unit 90, and the heater H is a temperature control unit which controls the temperature of the substrate W. Additionally, the two anode units 90 and 90 are movable in directions (horizontal directions) in which the anode units approach to and separate from each other using the drive device 71 provided at the side plate portion 63, and the separation distance between the substrate W and the cathode unit 68 can be controlled. Specifically, when forming films on the substrates W, the two anode units 90 and 90 move toward the cathode unit 68, and abut the substrates W, and further move in directions in which the anode units approach the cathode unit 68, thereby adjusting the separation distance between the substrates W and the cathode unit 68 to a desired distance. Thereafter, film formation are performed, and after the end of film forming, the anode units 90 and 90 move in the directions in which the anode units separate from each other, so that the substrates W can be easily taken out from the electrode unit 31.
Moreover, each anode unit 90 is attached to the drive device 71 via a hinge (not shown), and can be turned (opened) until the surface 67A of the anode unit 90 (anode 67) on the side of the cathode unit 68 becomes substantially parallel to the first surface 65 of the side plate portion 63, in a state in which the electrode unit 31 is pulled out of the film forming chamber 11. That is, as shown by a dotted line in FIG. 4A, the anode unit 90 can be turned by about 90° in plan view.

The cathode unit 68 has a shower plate 75 (cathode), a cathode intermediate member 76, a discharge duct 79, and a floating capacitance member 82.
Shower plates 75 formed with a plurality of small holes (not shown) are arranged on the surfaces of the cathode unit 68 which face the anode units 90 (anodes 67), so that the film forming gas can be jetted toward the substrates W. Moreover, the shower plates 75 and 75 are cathodes (high-frequency electrodes) connected to the matching box 72. The cathode intermediate member 76 connected to the matching box 72 is provided between the two shower plates 75 and 75. That is, the shower plates 75 are arranged on both sides of the cathode intermediate member 76 in a state where the shower plates are electrically connected to the cathode intermediate member 76. The cathode intermediate member 76 and the shower plates (cathodes) 75 are formed from electrical conductors, and high frequency is applied to the shower plates (cathodes) 75 via the cathode intermediate member 76. For this reason, voltages of the same potential and phase for generating plasma are applied to the two shower plates 75 and 75.
The cathode intermediate member 76 is connected to the matching box 72 by a wiring which is not shown. A space portion 77 is formed between the cathode intermediate member 76 and each shower plate 75, and the film forming gas is supplied to the space portion 77 from a gas supply apparatus (not shown). The space portions 77 are separated from each other by the cathode intermediate member 76, and are individually formed so as to correspond to the shower plates 75 and 75 respectively, so that the gases discharged from the respective shower plates 75 and 75 are controlled independently. That is, the space portion 77 has a function as a gas supply passage. In this embodiment, the space portions 77 are separately formed so as to correspond to the shower plates 75 and 75, respectively. Thus, the cathode unit 68 has two-types of gas supply passages.

Additionally, a hollow discharge duct 79 is provided at a peripheral edge portion of the cathode unit 68 over its whole circumference. The discharge duct 79 is formed with a vacuuming port 80 for evacuating the film forming gas or reactive by-products (powder) in a film formation space 81. Specifically, the vacuuming port 80 is formed so as to face the film formation space 81 which is formed between the substrate W and the shower plate 75 when forming a film. A plurality of vacuuming ports 80 are formed along the peripheral edge portion of the cathode unit 68, and is configured so that evacuation can be made substantially equal over its whole circumference. Additionally, the discharge duct 79 has a surface which faces the inside of the film forming chamber 11 at the lower portion of the cathode unit 68, and the surface of the discharge duct which faces the inside of the film forming chamber 11 is formed with an opening (not shown) so that the evacuated film forming gas can be discharged into the film forming chamber 11. The gas discharged into the film forming chamber 11 is evacuated to the outside through the vacuuming pipe 29 provided at the lateral lower portion 28 of the film forming chamber 11. Additionally, the floating capacitance member 82 which has at least a dielectric body or laminating space (a dielectric body and/or laminating space) is provided between the discharge duct 79 and the cathode intermediate member 76. The discharge duct 79 is connected to an installation potential. The discharge duct 79 also functions as a shield frame for preventing abnormal electrical discharge from the cathode 75 and the cathode intermediate member 76.

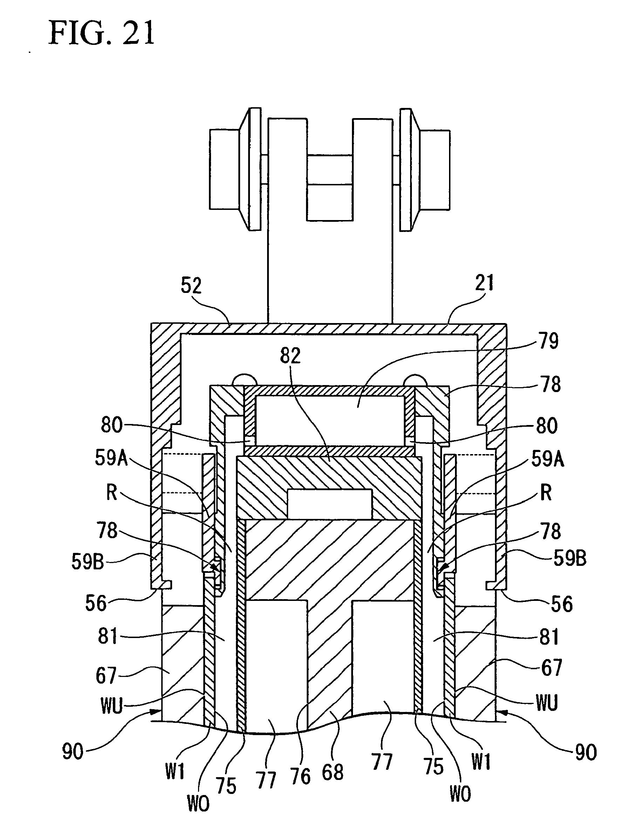

Moreover, masks 78 are provided at the peripheral edge portion of the cathode unit 68 so as to cover the part from the peripheral portion of the discharge duct 79 to the peripheral portion of the shower plate 75 (cathode). The masks 78 covers a holding piece 59A (refer to FIGS. 9 and 21) of a holding portion 59 (which will be described later) provided at the carrier 21, and forms a gas flow passage R for guiding the film forming gas or particles in the film formation space 81 to the discharge duct 79, integrally with the holding piece 59A when forming a film. That is, the gas flow passage R is formed between the carrier 21 (holding piece 59A) and the shower plate 75 or the discharge duct 79.

Since such an electrode unit 31 is provided, in one electrode unit 31, two gaps are formed between the anode units 90 and the cathode unit 68 into which substrates W are inserted. Accordingly, films can be simultaneously formed on two substrates W by one electrode unit 31.

Additionally, the substrate W is disposed between the anode unit 90 and the cathode unit 68, and the anode unit 90 (anode 67) abuts on the substrate W, and is movable in order to adjust the separation distance between the substrate W and the cathode unit 68. Accordingly, when a thin-film Si-layer is formed on the substrate W by the plasma CVD method, the gap between the substrate W and the cathode unit 68 should be set to about 5 mm to 15 mm. However, the separation distance between the anode 67 and the cathode unit 68 can be adjusted before and after film formation by moving the anode 67. Accordingly, entrance and exit of the substrate W can be made easier. Additionally, when the substrate W enters and exits, it is possible to prevent the substrate W from being damaged by contacting with the anode 67 or the cathode unit 68. Moreover, by abutting (contacting) the anode 67 and the substrate W, the heat of the heater H can be effectively transferred to the substrate W when a film is formed while the substrate W is heated by the heater H. Accordingly, high-quality film forming can be performed.

Moreover, since the electrode unit 31 is configured to be attachable to and detachable from the film forming chamber 11, the periodical maintenance of removing the films deposited on the cathode unit 68 and anode units 90 of the electrode unit 31 can be easily performed. Additionally, if a spare electrode unit 31 is prepared, while the above electrode unit 31 is removed from the film forming chamber 11 for maintenance, the spare electrode unit 31 is attached instead, so that maintenance can be performed without stopping the manufacturing line. Accordingly, production efficiency can be improved. As a result, high throughput can be realized even when a semiconductor layer is formed on the substrate W at a low rate.

Referring back to FIG. 2, the transfer rails 37 are laid over the film forming chamber 11, the loading-ejecting chamber 13, and the substrate replacement chamber 15. The carrier 21 can be transferred between the film forming chamber 11 and the loading-ejecting chamber 13 and between the loading-ejecting chamber 13 and the substrate replacement chamber 15 by using the transfer rails 37. In addition, the transfer rails 37 are separated between the film forming chamber 11 and the loading-ejecting chamber 13, and the carrier transfer inlet and outlet ports 24 can be sealed by closing the shutters 25.

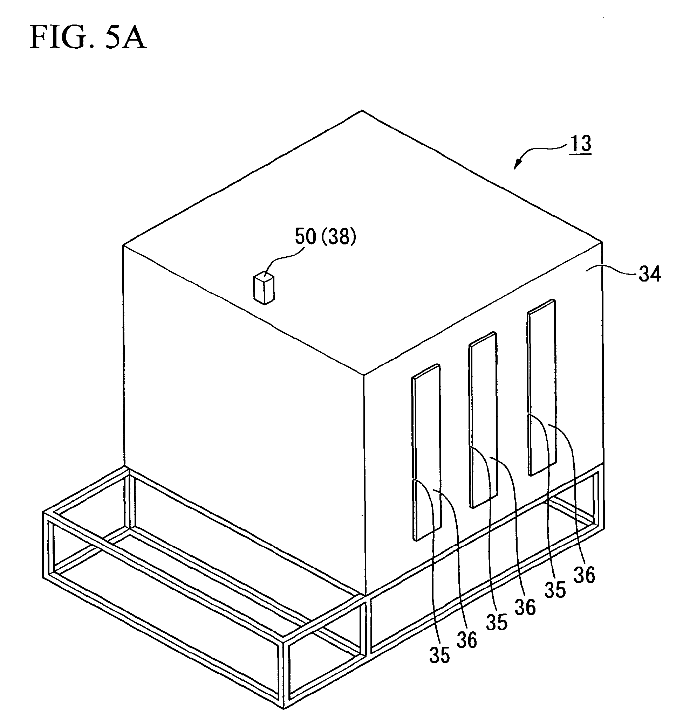

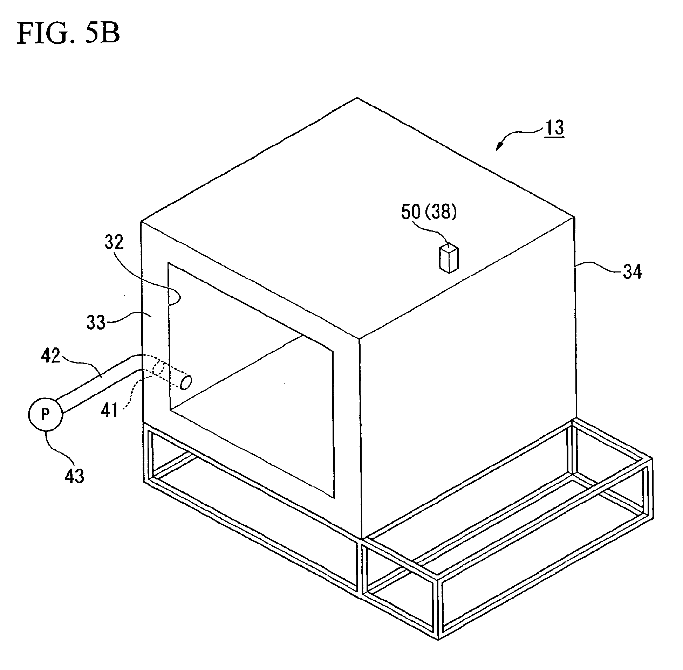

FIGS. 5A and 5B are views showing a schematic configuration of the loading-ejecting chamber 13, and FIG. 5A is a perspective view of the loading-ejecting chamber 13, and FIG. 5B is a perspective view as observed from an angle different from FIG. 5A. As shown in FIGS. 5A and 5B, the loading-ejecting chamber 13 is formed in a box shape. A side surface 33 of the loading-ejecting chamber 13 is connected to the side surface 23 of the film forming chamber 11 while securing airtightness. The side surface 33 of the loading-ejecting chamber 13 is formed with an opening 32 through which three carriers 21 can be inserted. A side surface 34 which is opposite to the side surface 33 of the loading-ejecting chamber 13 is connected to the substrate replacement chamber 15. The side surface 34 of the loading-ejecting chamber 13 is formed with three carrier transfer inlet and outlet ports 35 which allow the carrier 21 on which the substrates W are mounted to pass therethrough. Each carrier transfer inlet and outlet port 35 is provided with a shutter (second opening-closing part) 36 which can secure airtightness. In addition, the transfer rails 37 are separated between the loading-ejecting chamber 13 and the substrate replacement chamber 15, and the carrier transfer inlet and outlet ports 35 can be sealed by closing the shutters 36.

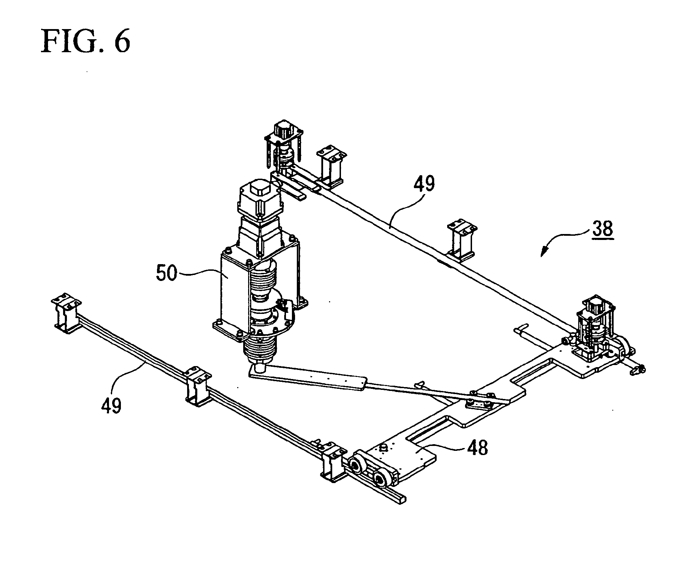

Additionally, the loading-ejecting chamber 13 is provided with a push-pull mechanism 38 (carrier transfer mechanism) for transferring the carrier 21 between the film forming chamber 11 and the loading-ejecting chamber 13 along the transfer rails 37. As shown in FIG 6, the push-pull mechanism 38 includes a locking portion 48 for locking the carrier 21; a pair of guide members 49 provided at both ends of the locking portion 48, and disposed substantially parallel to the transfer rails 37; and a transfer apparatus 50 for moving the locking portion 48 along the guide members 49.

Moreover, a transfer mechanism (not shown) for transferring the carrier 21 by a predetermined distance in a direction substantially orthogonal to a direction in which the transfer rails 37 are laid in plan view is provided within the loading-ejecting chamber 13 in order to simultaneously store the pre-processed substrate W1 and the post-processed substrate W2. A vacuuming pipe 42 for evacuating the inside of the loading-ejecting chamber 13 is connected to a lateral lower portion 41 of the loading-ejecting chamber 13, and a vacuum pump 43 is provided at the vacuuming pipe 42.

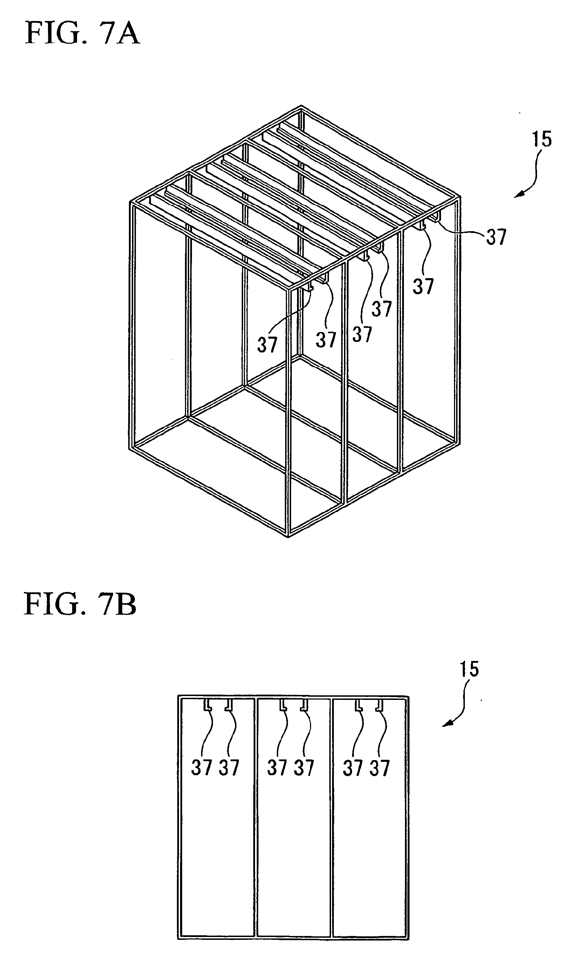

FIGS. 7A and 7B are views showing a schematic configuration of the substrate replacement chamber 15, FIG. 7A is a perspective view of the substrate replacement chamber 15, and FIG 7B is a front view of the substrate replacement chamber 15. As shown in FIGS. 7A and 7B, the substrate replacement chamber 15 is formed in the shape of a frame, and is connected to the side surface 34 of the loading-ejecting chamber 13. In the substrate replacement chamber 15, the pre-processed substrates W1 can be attached to the carrier 21 disposed at the transfer rails 37, and the post-processed substrates W2 can be removed from the carrier 21. Three carriers 21 are arranged in parallel at the substrate replacement chamber 15.

The substrate replacement robot 17 has a drive arm 45, and can suck the substrate W at the tip of the drive arm 45. Additionally, the drive arm 45 can be driven between the carrier 21 disposed at the substrate replacement chamber 15, and the substrate storage holder 19. That is, the drive arm 45 can remove the pre-processed substrates W1 from the substrate storage holder 19, and attach the pre-processed substrates W1 to the carrier 21 (first carrier) disposed at the substrate replacement chamber 15. Moreover, the drive arm 45 can remove the post-processed substrate W2 from the carrier (second carrier) 21 which has returned to the substrate replacement chamber 15, and can convey the post-processed substrate W2 to the substrate storage holder 19.

FIG. 8 is a perspective view of the substrate storage holder 19. As shown in FIG. 8, the substrate storage holder 19 is formed in a box shape, and has a size such that the holder can store a plurality of substrates W. A plurality of substrates W can be stacked and stored in the up-and-down direction in a state where the surfaces to be film-formed of the substrates are made substantially parallel to the horizontal direction. Additionally, casters 47 are provided at a lower portion of the substrate storage holder 19 so as to allow for movement to the other processing apparatuses. In addition, a plurality of substrates W can be stored in the right-and-left direction in the substrate storage holder 19 in a state where the surfaces to be film-formed of the substrates W are made substantially parallel to the direction of gravitational force.

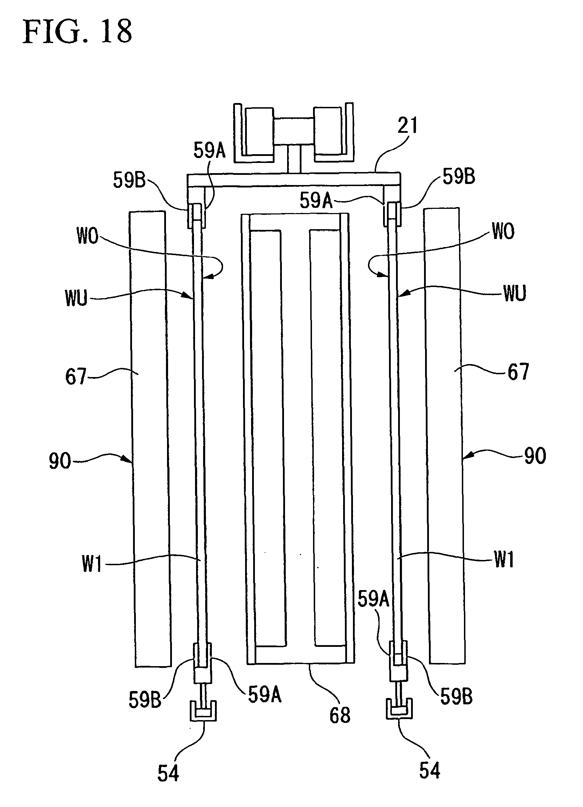

FIG. 9 is a perspective view of the carrier 21. As shown in FIG. 9, the carrier 21 is formed with two architrave-like frames 51 to which the substrates W can be attached. That is, two substrates W can be attached to one carrier 21. Two frames 51 and 51 are integrated together by a connection member 52 at the upper portions thereof. Additionally, a plurality of wheels 53 placed on the transfer rails 37 is provided above the connection member 52 so that the carrier 21 can be transferred as the wheels 53 roll on the transfer rails 37. Additionally, a lower portion of each frame 51 is provided with a frame holder 54 for suppressing the shaking of the substrate W when the carrier 21 is transferred. The tip of the frame holder 54 is fitted into a rail member 55 (refer to FIG. 18) with a concave cross-section provided on the bottoms of the film forming chamber 11, loading-ejecting chamber 13, and substrate replacement chamber 15. In addition, the rail members 55 are disposed in a direction along the transfer rails 37 in plan view. The substrate W can be more stably conveyed if the frame holder 54 is constituted by a plurality of rollers.

Each frame 51 has an opening 56, a peripheral edge portion 57, and a holding portion 59. The surface to be film-formed (front surface WO) of the substrate W is exposed to the opening 56 formed in the frame 51, and the holding portion 59 holds and fixes the substrate W from both sides at the peripheral edge portion 57 of the opening 56. A biasing force caused by a spring or the like acts on the holding portion 59 which holds the substrate W. Additionally, the holding portion 59 has holding pieces 59A and 59B which abut on the front surface WO which is the surfaces to be film-formed of the substrate W and the rear surface WU (back surface) (refer to FIGS. 18 and 21). The separation distance between the holding pieces 59A and 59B is variable via the spring or the like. That is, the holding piece 59A can move along the directions in which the holding piece approaches and separates from the holding piece 59B according to the movement of the anode unit 90 (anode 67) (the details thereof will be described later). Here, one carrier 21 (one carrier which can hold a pair of (two) substrates) is attached onto one transfer rail 37. That is, three carriers 21 (which can hold three pairs of (six) substrates) are attached to one thin-film solar cell manufacturing apparatus 10.

Also, in the thin-film solar cell manufacturing apparatus 10 of the present embodiment, four substrate film formation lines 16 each including the above-described film forming chamber 11, loading-ejecting chamber 13, and substrate replacement chamber 15 are arranged. Accordingly, films can be substantially simultaneously formed on twenty four substrates W.

### <Manufacturing method of Thin-film Solar Cell>

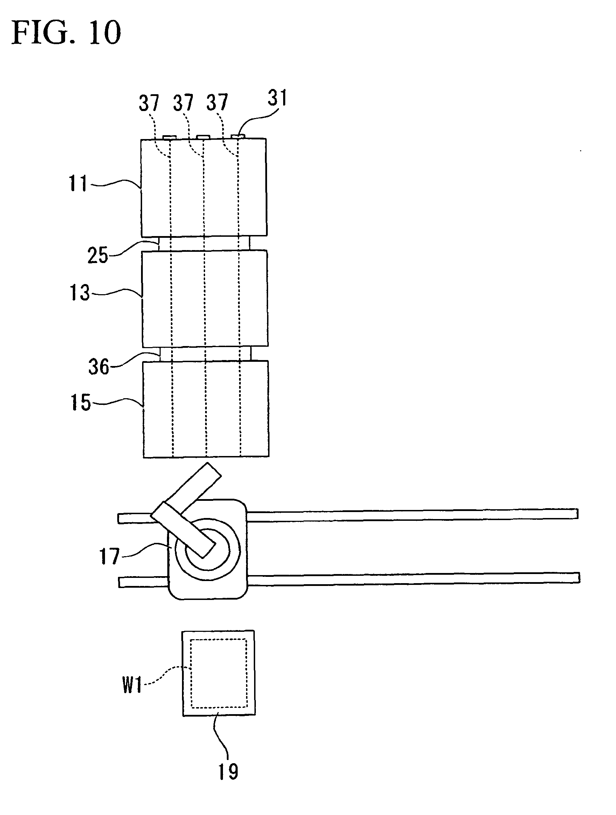

Next, a method for forming a film on a substrate W using the thin-film solar cell manufacturing apparatus 10 of the present embodiment will be described. In addition, although drawings of one substrate film formation line 16 are used in this description, the other three substrate film formation lines 16 also form films on substrates according to almost the same flow.
As shown in FIG. 10, the substrate storage holder 19 which stores a plurality of pre-processed substrates W1 is arranged at a predetermined position.

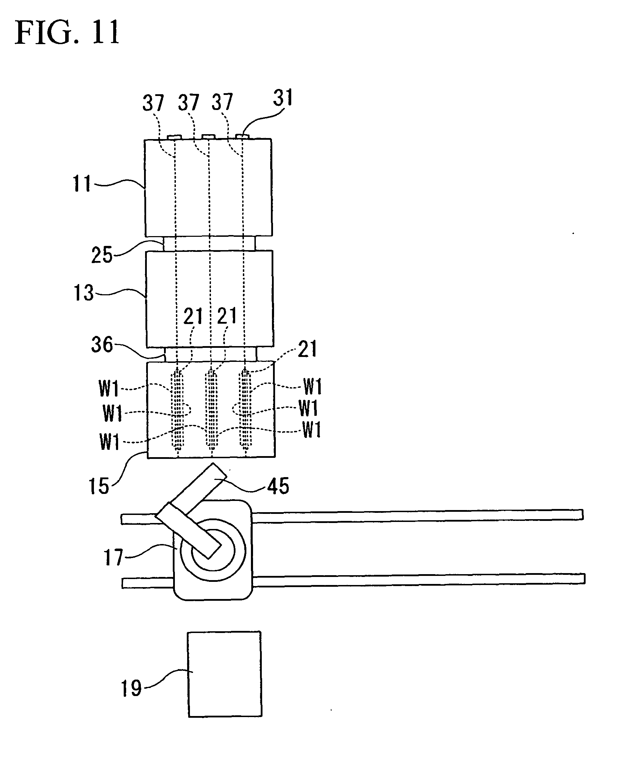

As shown in FIG. 11, the drive arm 45 of the substrate replacement robot 17 is operated to take a piece of pre-processed substrate W1 out of the substrate storage holder 19, and attaches the pre-processed substrate W1 to a carrier 21 installed in the substrate replacement chamber 15. At this time, the pre-processed substrate W1 which has been arranged in the horizontal direction in the substrate storage holder 19 is attached to the carrier 21 after its orientation is changed to the vertical direction. This operation is repeated once again to attach a second pre-processed substrate W1 to one carrier 21. Moreover, this operation is repeated to attach the pre-processed substrates W1 even to the remaining two carriers 21 installed in the substrate replacement chamber 15, respectively. That is, six pre-processed substrates W1 are attached to the carriers 21 in this step.

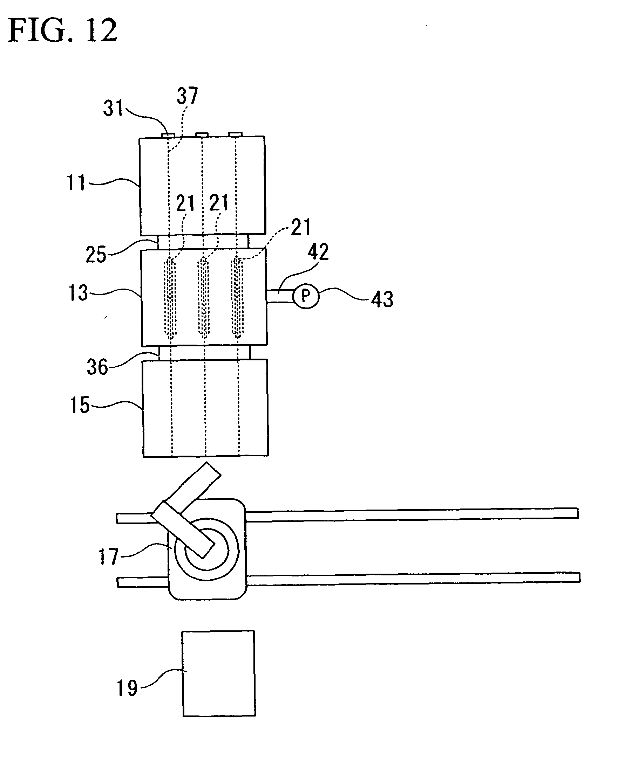

As shown in FIG. 12, the three carriers 21 to which the pre-processed substrates W1 are attached are substantially simultaneously transferred along the transfer rails 37, and are stored within the loading-ejecting chamber 13. After the carriers 21 are stored within the loading-ejecting chamber 13, the shutters 36 of the carrier transfer inlet and outlet ports 35 of the loading-ejecting chamber 13 are closed. Thereafter, the inside of the loading-ejecting chamber 13 is held in a vacuum state using the vacuum pump 43.

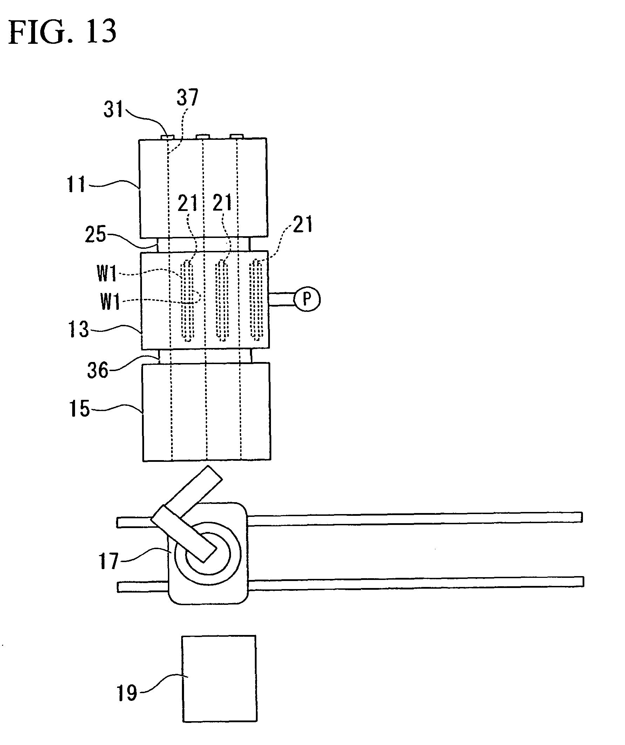

As shown in FIG. 13, the three carriers 21 are transferred using the transfer mechanism by a predetermined distance (half pitch), respectively, in a direction orthogonal to a direction in which the transfer rails 37 are laid in plan view. In addition, this predetermined distance is a distance where one carrier 21 is located between adjacent transfer rails 37 and 37.

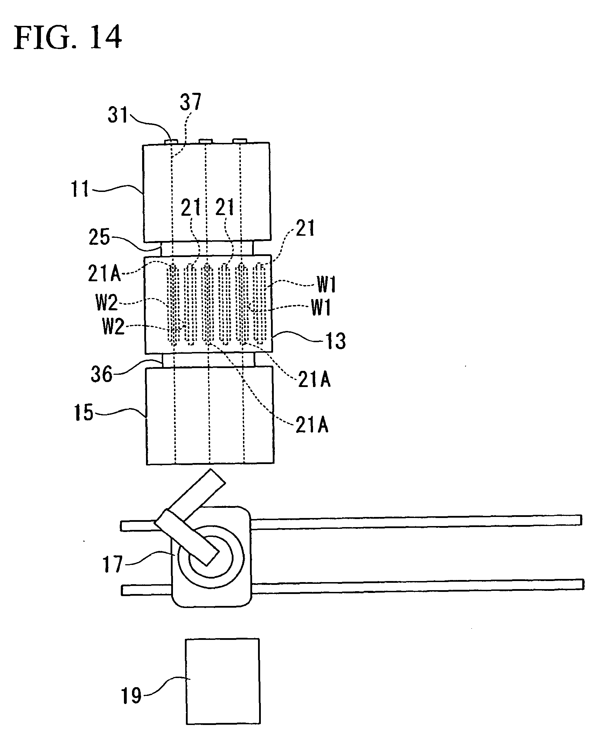

As shown in FIG. 14, the shutters 25 of the film forming chamber 11 are brought into an opened state, and the carriers 21 A, to which the post-processed substrates W2 of which the film forming has been ended in the film forming chamber 11 are attached, are transferred to the loading-ejecting chamber 13, using the push-pull mechanism 38. At this time, the carriers 21 and the carriers 21 A are alternately arranged in parallel in plan view. By maintaining this state for a predetermined time, the heat which is accumulated in the post-processed substrates W2 is transferred to the pre-processed substrates W1. That is, the substrates W1 are heated before film forming.

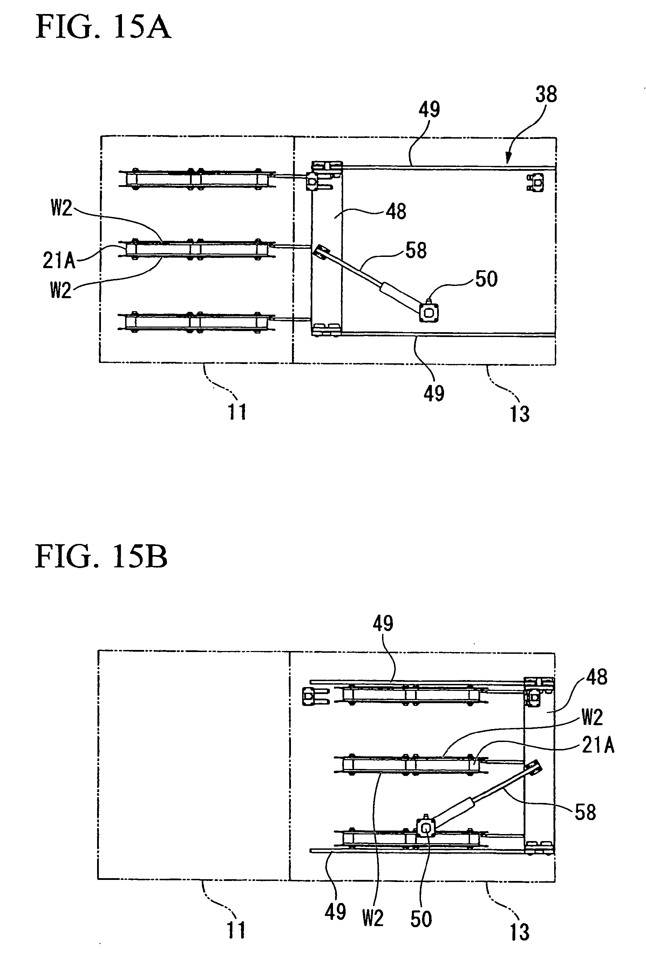

Here, the operation of the push-pull mechanism 38 will be described. In addition, the operation when the carriers 21 A located in the film forming chamber 11 are transferred into the loading-ejecting chamber 13 will be described here.
As shown in FIG 15A, the carriers 21A to which the post-processed substrates W2 are attached are locked to the locking portion 48 of the push-pull mechanism 38. Then, the transfer arm 58 of the transfer apparatus 50 which are attached to the locking portion 48 is swung. At this time, the length of the transfer arm 58 is variable. Then, the locking portion 48 to which the carriers 2 1 A have been locked is guided by the guide members 49, and is moved along the guide members 49. As shown in FIG 15B, the carriers 21A locked to the locking portion 48 are transferred into the loading-ejecting chamber 13. That is, the carriers 21A are transferred to the loading-ejecting chamber 13 from the film forming chamber 11. By adopting such a configuration, it becomes unnecessary to install a drive source for driving the carriers 21A within the film forming chamber 11. In addition, the carriers 21 within the loading-ejecting chamber 13 are transferred into the film forming chamber 11, by performing an operation which is opposite to the above described operation.

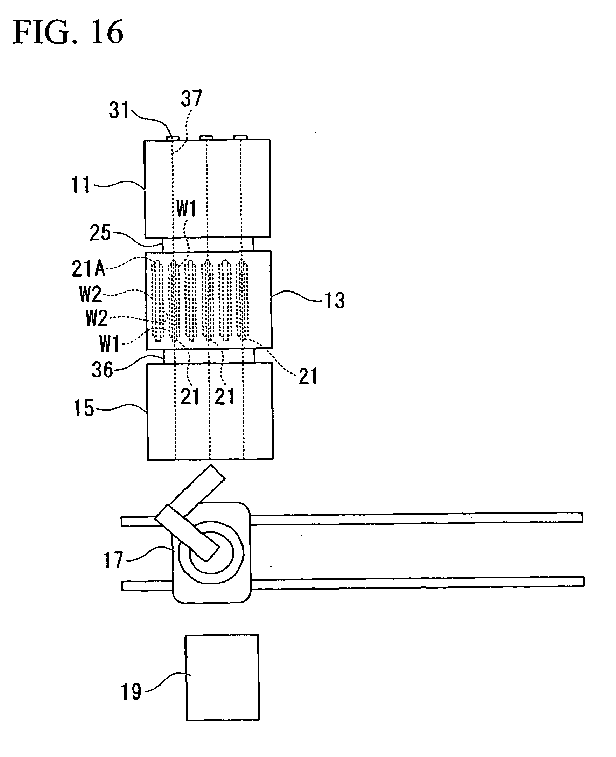

As shown in FIG 16, the carriers 21 and the carriers 21 A are transferred in a direction orthogonal to the transfer rails 37 by the transfer mechanism, and the carriers 21 holding the pre-processed substrates W1 are transferred to positions along the transfer rails 37.

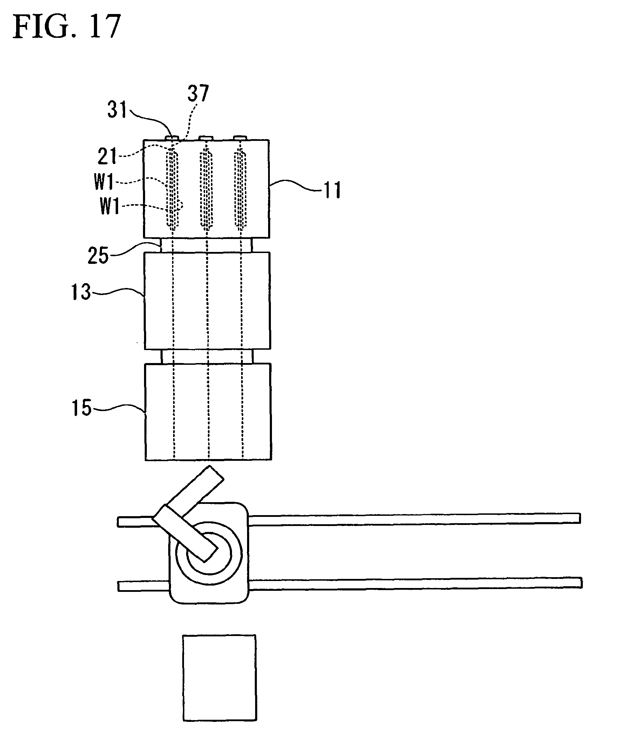

As shown in FIG. 17, the carriers 21 holding the pre-processed substrates W1 are transferred to the film forming chamber 11, using the push-pull mechanism 38, and the shutters 25 are brought into a closed state after the completion of the transfer. In addition, a vacuum state is held in the film forming chamber 11. At this time, the pre-processed substrates W1 attached to the carrier 21 are inserted into between the anode units 90 and the cathode unit 68 in a state where the front surfaces WO thereof run along the vertical direction substantially parallel to the direction of gravitational force within the film forming chamber 11 (refer to FIG. 18).

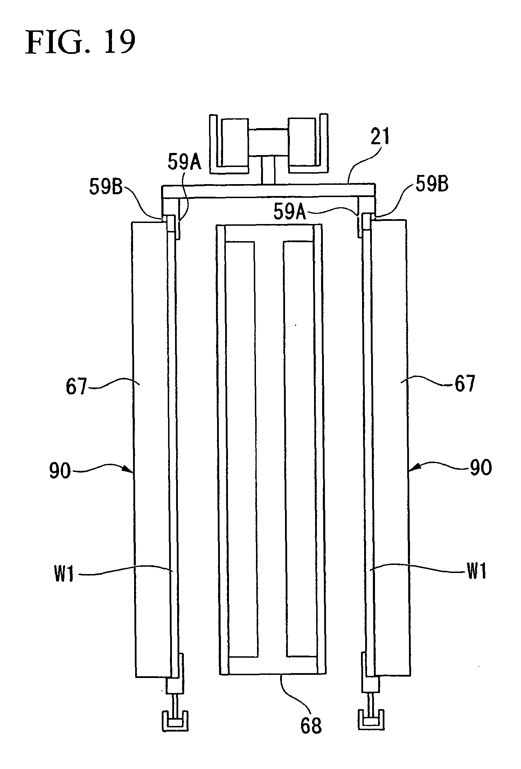

As shown in FIGS. 18 and 19, the anode units 90 and the rear surfaces WU of the pre-processed substrates W1 are made to abut on each other by moving the two anode units 90 (anodes 67) of the electrode unit 31 in a direction in which the anode units approach each other using the drive device 71.

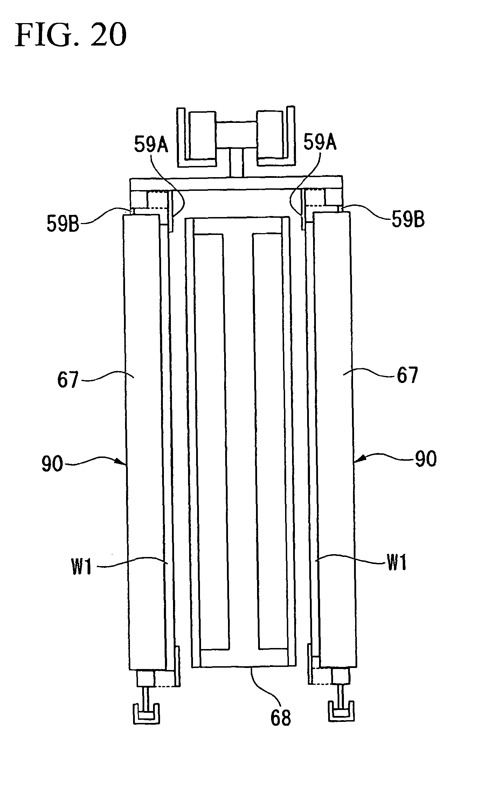

As shown in FIG. 20, when the drive device 71 is further driven, the pre-processed substrates W1 move toward the cathode unit 68 so as to be pushed by the anodes 67. Then, the pre-processed substrates are moved until the gap between the pre-processed substrate W1 and the shower plate 75 of the cathode unit 68 reaches a predetermined distance (film forming distance). In addition, the gap (film forming distance) between the pre-processed substrate W1 and the shower plate 75 of the cathode unit 68 is 5 mm to 15 mm, and is, for example, about 5 mm.

At this time, the holding piece 59A of the holding portion 59 of the carrier 21 which abuts on the front surface WO of the pre-processed substrate W1 is displaced along with the movement of the pre-processed substrates W1 (of the anode unit 90). In addition, when the anode unit 90 has moved toward the direction away from the cathode unit 68, the restoring force of the spring or the like acts on the holding piece 59A so that this holding piece is displaced toward the holding piece 59B. The pre-processed substrate W1 at this time is held by the anode 67 and the holding piece 59A.

As shown in FIG 21, when the pre-processed substrates W1 moves toward the cathode unit 68, the holding piece 59A abuts on the mask 78, and the movement of the anode unit 90 stops at this time.
Here, as shown in FIG. 21, the mask 78 is formed so as to cover the surface of the holding piece 59A and the outer-edge portion of the substrate W and come into close contact with the holding piece 59A or the outer-edge portion of the substrate W. That is, a mating surface between the mask 78 and the holding piece 59A or a mating surface between the mask 78 and the outer-edge portion of the substrate W has a function as a seal surface so that the film forming gas does not leak out from between the mask 78 and the holding piece 59A or between the mask 78 and the outer-edge portion of the substrate W to anode 67 side. This limits the range where the film forming gas spreads, and can keep a film being formed in an unnecessary range. Thereby, the cleaning range can be narrowed, the cleaning frequency can be reduced, and the operating rate of the apparatus improved.
Additionally, since the movement of the pre-processed substrate W1 stops when the outer-edge portion of the substrate W abuts on the mask 78, the flow passage height of the gas flow passage R in a thickness direction, which is formed by the gap between the mask 78 and the shower plate 75 and between the mask 78 and the discharge duct 79, is set so that the gap between the pre-processed substrate W1 and the cathode unit 68 reaches a predetermined distance.
As another aspect, the distance between the substrate W and the shower plate 75 (cathode) can also be arbitrarily changed by the stroke of the drive mechanism 71 by attaching the mask to the discharge duct 79 via an elastic body. A case where the mask 78 and the substrate W abut on each other has been described above. However, the mask 78 and the substrate W may be arranged so as to leave a minute gap which limits the passage of the film forming gas.

In such a state, the film forming gas is jetted from the shower plate 75 of the cathode unit 68, and the matching box 72 is started to apply a voltage to the shower plate (cathode) 75 of the cathode unit 68, thereby generating plasma in the film formation space 81 to form a film on the front surface WO of the pre-processed substrate W1. At this time, the pre-processed substrate W1 is heated to a desired temperature by the heater H built in the anode 67.

Here, the anode unit 90 stops heating when the pre-processed substrate W1 reaches a desired temperature. However, plasma is generated within the film formation space 81 by applying a voltage to the cathode unit 68. Even if the heating of the anode unit 90 is stopped, there is a possibility that the temperature of the pre-processed substrate W1 may rise higher than a desired temperature due to the heat input from the plasma with the passage of time. In this case, the anode unit 90 can also be made to function as a radiator plate for cooling the pre-processed substrate W1 where the temperature has risen excessively. Accordingly, the temperature of the pre-processed substrate W1 is maintained at a desired temperature irrespective of the passage of the film formation processing time.
In addition, when a plurality of layers is formed through one film formation processing process, a film forming gas material to be supplied can be changed every predetermined time.

During film forming and after film forming, the gas or particles in the film formation space 81 are evacuated from the vacuuming ports 80 formed in the peripheral edge portion of the cathode unit 68. Along with this, the evacuated gas passes through the opening (opening formed in the surface of the discharge duct 79 which faces the inside of the film forming chamber 11 at the lower portion of the cathode unit 68) from the discharge duct 79 at the peripheral edge portion of the cathode unit 68 via the gas flow passage R, and flows to the outside from the vacuuming pipe 29 provided at the lateral lower portion 28 of the film forming chamber 11. In addition, the reactive by-products (powder) generated when forming a film can be collected and disposed of when being made to adhere to the inner wall surface of the discharge duct 79. Since the same processing as the above-described processing is performed in all the electrode units 31 within the film forming chamber 11, film forming can be simultaneously performed on six substrates.

When the film forming is ended, the two anode units 90 are moved in directions away from each other by the drive device 71, and the post-processed substrate W2 and the frames 51 (holding pieces 59A) are returned to their original positions (refer to FIGS. 19 and 21). Moreover, by moving the anode units 90 in directions away from each other, the post-processed substrate W2 and the anode units 90 are separated from each other (refer to FIG. 18).

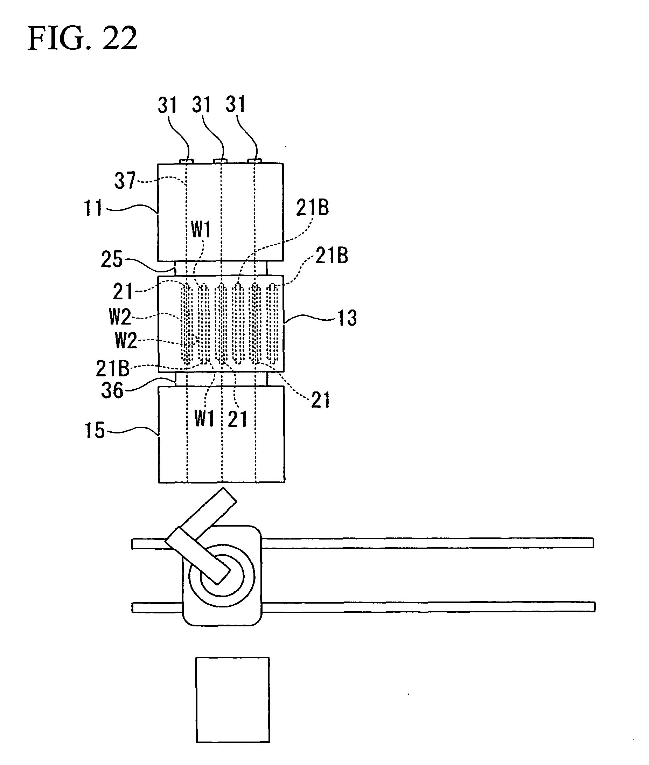

As shown in FIG. 22, the shutters 25 of the film forming chamber 11 are brought into an opened state, and the carriers 21 are transferred to the loading-ejecting chamber 13, using the push-pull mechanism 38. At this time, the loading-ejecting chamber 13 is evacuated, and the carrier 21B to which the pre-processed substrates W1 to be film-formed next are already located. Then, the heat accumulated in the post-processed substrates W2 is transferred to the pre-processed substrates W1 within the loading-ejecting chamber 13, and the temperature of the post-processed substrates W2 is lowered.

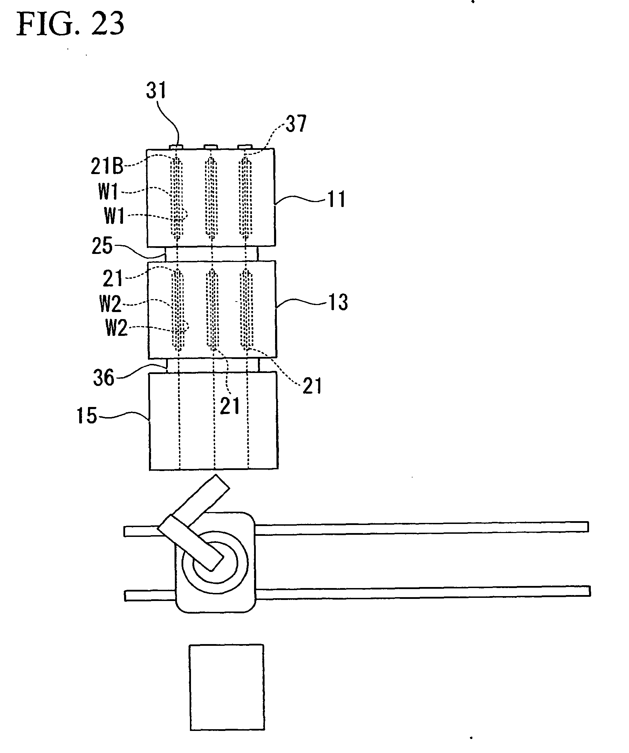

As shown in FIG. 23, after the carrier 21 B is transferred into the film forming chamber 11, the carrier 21 is returned to a position arranged on the transfer rails 37 by the transfer mechanism.

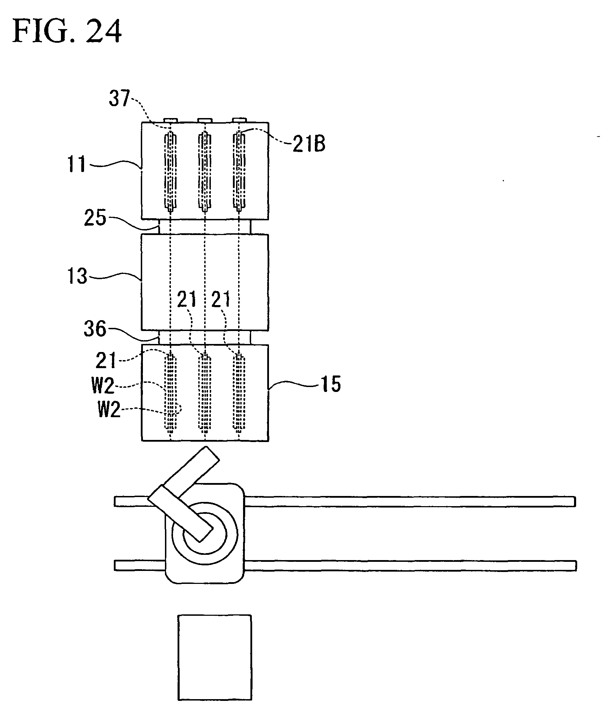

As shown in FIG. 24, after the shutters 25 are brought into a closed state, and the temperature of the post-processed substrate W2 is lowered to a predetermined temperature, the shutters 36 are brought into an opened state, and the carriers 21 are transferred to the substrate replacement chamber 15.

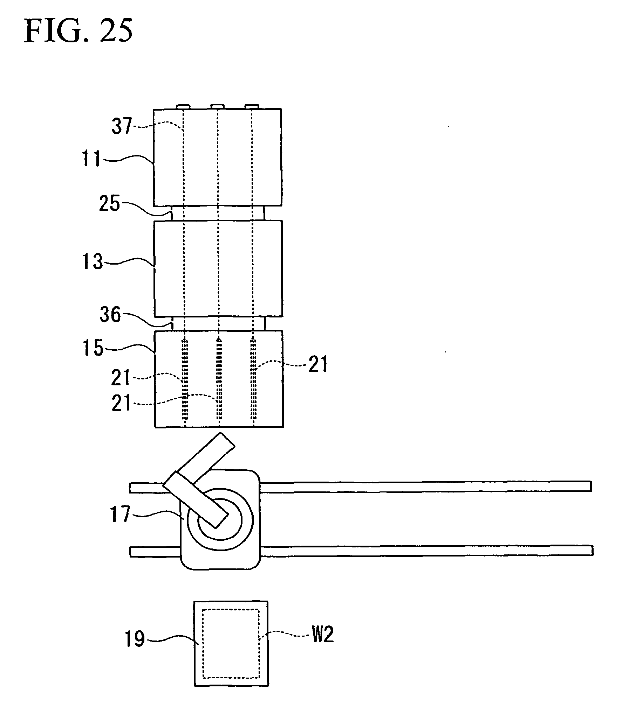

As shown in FIG. 25, the post-processed substrate W2 is removed from the carrier 21 by the substrate replacement robot 17 in the substrate replacement chamber 15, and the post-processed substrate W2 is conveyed to the substrate storage holder 19. When removal of all the post-processed substrates W2 is completed, the processing is ended by moving the substrate storage holder 19 to a place for the following process.

According to the thin-film solar cell manufacturing apparatus 10 of the present embodiment, the carrier 21 (21A) holding the post-processed substrate W2 and the carrier 21 holding the pre-processed substrates W1 can be simultaneously stored in the loading-ejecting chamber 13. Therefore, the evacuation process can be reduced by half in a series of substrate film forming processes of the loading-ejecting chamber 13. That is, an evacuation process which is performed in the stage where a carrier holding a pre-processed substrate is stored in a conventional loading chamber, and an evacuation process which is performed before a carrier holding a post-processed substrate is stored in an ejecting chamber can be simultaneously performed. Accordingly, productivity can be markedly improved. Additionally, when the post-processed substrate W2 and the pre-processed substrate W1 are simultaneously stored in the loading-ejecting chamber 13, the heat accumulated in the post-processed substrate W2 is transferred to the pre-processed substrate W1, whereby heat exchange is positively performed. That is, a heating process which is usually performed after the pre-processed substrate W1 is stored in the film forming chamber 11, and a cooling process which is usually performed before the post-processed substrate W2 is carried out of the loading-ejecting chamber 13 can be omitted. As a result, the heating process and the cooling process become unnecessary, productivity can be improved, and the conventional devices used for the heating process and the cooling process can be reduced. Therefore, space saving and lower cost can be simultaneously achieved.

Additionally, in the loading-ejecting chamber 13, the carrier 21 on which the pre-processed substrates W1 are mounted and the carrier 21 (21 A) on which the post-processed substrates W2 are mounted are alternately arranged in plan view. Accordingly, when the post-processed substrates W2 and the pre-processed substrates W1 are simultaneously stored in the loading-ejecting chamber 13, the heat accumulated in the post-processed substrate W2 is efficiently transferred to the pre-processed substrates W1, so that heat exchange can be performed reliably.

Additionally, in order to simultaneously store the carrier 21 holding the pre-processed substrates W1 and the carrier 21 (21A) holding the post-processed substrates W2 in the loading-ejecting chamber 13, the substrates W (carrier 21) is movable in a direction substantially perpendicular to a moving direction (direction along the transfer rails 37) to the film forming chamber 11 in plan view. By adopting such a configuration, the transfer rails 37 along which the substrate W enters and exits the loading-ejecting chamber 13 can be fixed. That is, one certain carrier 21 always moves between chambers along the same transfer rails 37. Accordingly, the size of the apparatus itself can be kept down, and the installation space of the apparatus can be reduced.

Additionally, in the present embodiment, transfer and film formation processing within the thin-film solar cell manufacturing apparatus 10 are performed in a state where the substrate W is erected in the vertical direction (state where the substrate W is arranged so that the surface to be film-formed thereof becomes parallel to the direction of gravitational force). As a result, the area required for a substrate W to move within the thin-film solar cell manufacturing apparatus 10 can be reduced to miniaturize the apparatus, and a larger number of apparatuses can be arranged in the same installation area as a conventional technique. Accordingly, the number of substrates W on which films are simultaneously formed can be increased, and productivity can be improved. Additionally, when a film is formed on a substrate W in a state where the substrate is erected in the vertical direction, particles generated when forming a film can be kept from depositing on the film formation face of the substrate W. Accordingly, a high-quality semiconductor layer can be formed on the substrate W.

Additionally, since the carrier 21 can hold a plurality of (two) substrates W, films can be simultaneously formed on a plurality of substrates W in one carrier 21, and productivity can be further improved. Moreover, since a plurality of carriers 21 can be simultaneously conveyed to the film forming chamber 11, the processing rate can be further raised.

Moreover, since a plurality of process modules 14 in which the film forming chamber 11 and the loading-ejecting chamber 13 are connected to is configured so as to be arranged in parallel, the number of substrates W on which films can be simultaneously formed can be further increased, and even when a semiconductor layer is formed on a substrate W at a low rate, high throughput can be realized. Additionally, the installation time (building time of a manufacturing line) of the apparatus when the manufacturing line is built in a factory or the like can be shortened by integrating the apparatus as the process module 14. Moreover, when maintenance of the film forming chamber 11 is performed, it becomes unnecessary to stop the whole manufacturing line by performing the maintenance for every process module 14. Accordingly, a decrease in production efficiency during maintenance can be suppressed to a minimum.

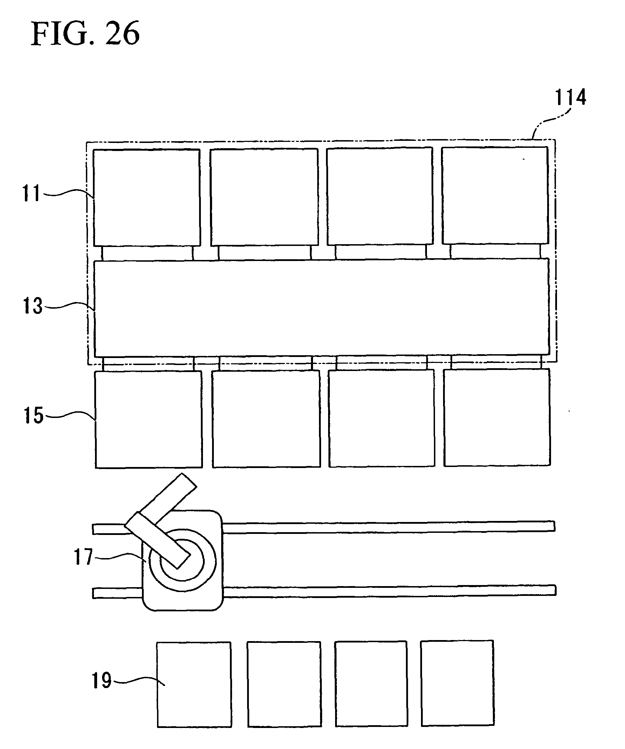

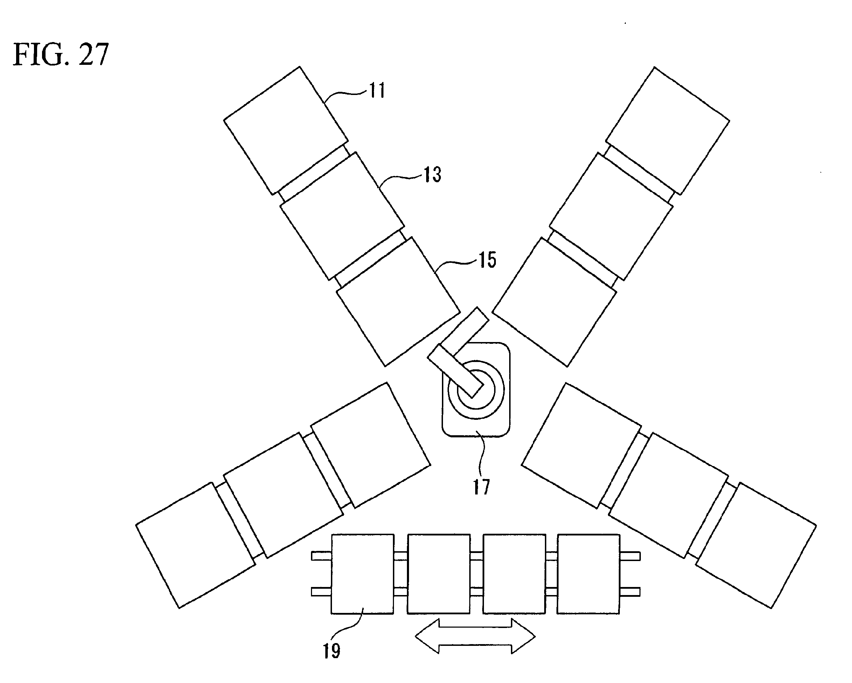

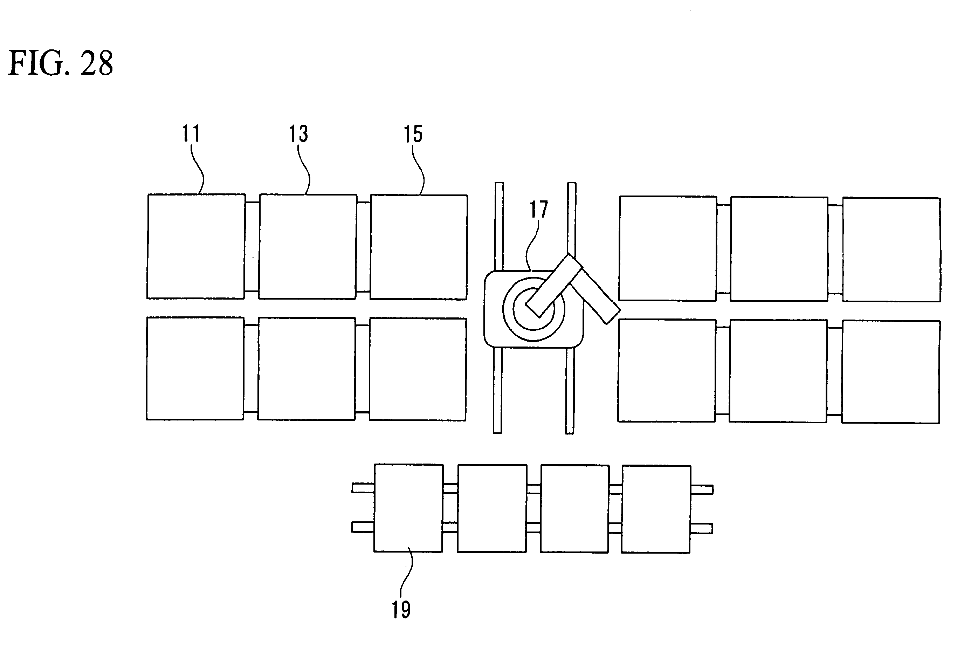

In addition, it should be understood that the technical scope of the present invention is not limited to the above-described embodiment, but that various modifications of the above-described embodiment may be made without departing from the scope of the invention. That is, the specific shapes and configurations as mentioned in the embodiment are merely examples, and can be appropriately changed.
For example, although the case where one loading-ejecting chamber is connected to one film forming chamber has been described in the present embodiment, as shown in FIG. 26, a process module 114 in which a plurality of film forming chambers 11 is arranged in parallel and is connected to one big loading-ejecting chamber 13 may be provided so that a carrier can transfer the loading-ejecting chamber 13. By adopting such a configuration, a substrate attached to a carrier can be moved within the loading-ejecting chamber. Therefore, different film forming materials can be supplied in the film forming chambers, respectively. Thereby, a plurality of layers with different film forming materials can be more efficiently formed on a substrate.
Additionally, the thin-film solar cell manufacturing apparatus may be arranged as shown in FIG. 27. In this example, modules each including the film forming chamber 11, the loading-ejecting chamber 13, and the substrate replacement chamber 15 are radially installed at the substrate replacement robot 17. By adopting such a configuration, the time for which the substrate replacement robot 17 moves on the rails can be eliminated. That is, the operating time of the substrate replacement robot 17 can be shortened, and the tact time can be shortened.
Moreover, the thin-film solar cell manufacturing apparatus may be arranged as shown in FIG. 28. In this example, modules each including the film forming chamber 11, the loading-ejecting chamber 13, and the substrate replacement chamber 15 are installed on both sides of the substrate replacement robot 17. By adopting such a configuration, space can be saved, and the operating time of the substrate replacement robot can be shortened.
In the present embodiment, in the loading-ejecting chamber 13, the carrier holding the pre-processed substrates W1 and the carrier holding the post-processed substrates W2 are alternately arranged in plan view. However, these carriers may have arrangements other than the alternate arrangement.

### [Industrial Applicability]

According to the embodiment of the present invention, the heating process and the cooling process which are usually performed can be omitted. Therefore, productivity can be improved, and the conventional devices used for the heating process and the cooling process can be reduced. Therefore, space saving and lower cost can be simultaneously achieved.

### [Description of the Reference Numerals]

- 10:: THIN-FILM SOLAR CELL MANUFACTURING APPARATUS
- 11:: FILM FORMING CHAMBER
- 13:: LOADING-EJECTING CHAMBER
- 14:: SUBSTRATE FILM FORMATION MODULE
- 15:: SUBSTRATE REPLACEMENT CHAMBER
- 21:: CARRIER
- 25:: SHUTTER (FIRST OPENING-CLOSING PART)
- 104:: BOTTOM CELL (FILM)
- W:: SUBSTRATE
- W1:: PRE-PROCESSED SUBSTRATE
- W2:: POST-PROCESSED SUBSTRATE

## Claims

1. A thin-film solar cell manufacturing apparatus (10) comprising:
a film forming chamber (11) that is evacuated to a reduced pressure and forms a film on a substrate using a CVD method;
a loading-ejecting chamber (13) that is connected to the film forming chamber via a first opening-closing part and that is switchable between atmospheric pressure and reduced pressure;
a first carrier (21) that holds a pre-processed substrate (W1); and
a second carrier (21A) that holds a post-processed substrate (W2), wherein the first carrier (21) and the second carrier (21A) hold the substrate (W1, W2) in a vertical posture where a surface to be film-formed of the substrate (W1, W2) is parallel to a direction of gravitational force;
the loading-ejecting chamber (13) simultaneously stores a plurality of the first carriers (21) and a plurality of the second carriers(21 A) in a state where the internal pressure of the loading-ejecting chamber (13) is reduced;
the first carriers (21) and the second carriers (21 a) are alternately arranged in parallel in the loading-ejecting chamber (13); and
the first carriers (21) and the second carriers (21A) are movable in a direction substantially perpendicular to a moving direction toward the film forming chamber (11) within the loading-ejecting chamber (13).

2. The thin-film solar cell manufacturing apparatus (10) according to claim 1, wherein the first carrier (21) and the second carrier (21A) hold a plurality of the substrates (W1, W2) so that the substrates (W1, W2) are parallel to each other and face each other.

3. The thin-film solar cell manufacturing apparatus (10) according to claim 1, wherein the loading-ejecting chamber (13) has a carrier transfer mechanism (38) which collectively transfers a plurality of the second carriers (21A) to the loading-ejecting chamber (13) from the film forming chamber (11).

4. The thin-film solar cell manufacturing apparatus (10) according to claim 3, wherein the carrier transfer mechanism (38) collectively transfers a plurality of the first carriers (21) to the film forming chamber (11) from the loading-ejecting chamber (13).

5. The thin-film solar cell manufacturing apparatus (10) according to claim 1, further comprising a plurality of process modules in which one film forming chamber (11) is connected to one loading-ejecting chamber (13), wherein the plurality of process modules is arranged in parallel.

6. The thin-film solar cell manufacturing apparatus (10) according to claim 1, wherein a plurality of the film forming chambers (11) is connected to one loading-ejecting chamber (13).

## Patentansprüche

1. Dünnfilm-Solarzellenherstellungsvorrichtung (10), umfassend:
eine Filmbildungskammer (11), die auf einen reduzierten Druck evakuiert ist und einen Film auf einem Substrat mittels eines CVD-Verfahrens bildet;
eine Lade-Auswurf-Kammer (13), die mit der Filmbildungskammer über einen ersten Öffnungs-Schließ-Abschnitt verbunden ist, und die zwischen atmosphärischem Druck und reduziertem Druck umschaltbar ist;
einen ersten Träger (21), der ein vorverarbeitetes Substrat (W1) hält;
einen zweiten Träger (21A), der ein nachbearbeitetes Substrat (W2) hält,
wobei der erste Träger (21) und der zweite Träger (21A) das Substrat (W1, W2) in einer vertikalen Positur halten, in der eine Oberfläche des Substrats (W1, W2), auf der ein Film gebildet werden soll, parallel zu einer Richtung der Gravitationskraft ist;
wobei die Lade-Auswurf-Kammer (13) gleichzeitig eine Mehrzahl der ersten Träger (21) und eine Mehrzahl der zweiten Träger (21A) in einem Zustand aufnimmt, in dem der interne Druck der Lade-Auswurf-Kammer (13) reduziert ist;
wobei die ersten Träger (21) und die zweiten Träger (21A) wechselweise parallel in der Lade-Auswurf-Kammer (13) angeordnet sind; und
wobei die ersten Träger (21) und die zweiten Träger (21A) innerhalb der Lade-Auswurf-Kammer (13) bewegbar sind in einer Richtung, die im Wesentlichen senkrecht zu einer Bewegungsrichtung auf die Filmbildungskammer (11) zu ist.

2. Dünnfilm-Solarzellenherstellungsvorrichtung (10) nach Anspruch 1, wobei der erste Träger (21) und der zweite Träger (21A) eine Mehrzahl der Substrate (W1, W2) so halten, dass die Substrate (W1, W2) zueinander parallel sind und sich gegenüberstehen.

3. Dünnfilm-Solarzellenherstellungsvorrichtung (10) nach Anspruch 1, wobei die Lade-Auswurf-Kammer (13) einen Trägertransfermechanismus (38) aufweist, der kollektiv eine Mehrzahl der zweiten Träger (21A) von der Filmbildungskammer (11) zu der Lade-Auswurf-Kammer (13) transferiert.

4. Dünnfilm-Solarzellenherstellungsvorrichtung (10) nach Anspruch 3, wobei der Trägertransfermechanismus (38) kollektiv eine Mehrzahl der ersten Träger (21) von der Lade-Auswurf-Kammer (13) zu der Filmbildungskammer (11) transferiert.

5. Dünnfilm-Solarzellenherstellungsvorrichtung (10) nach Anspruch 1, desweiteren umfassend eine Mehrzahl von Verarbeitungsmodulen, in denen eine Filmbildungskammer (11) mit einer Lade-Auswurf-Kammer (13) verbunden ist, wobei die Mehrzahl von Verarbeitungsmodulen parallel zueinander angeordnet ist.

6. Dünnfilm-Solarzellenherstellungsvorrichtung (10) nach Anspruch 1, wobei eine Mehrzahl der Filmbildungskammern (11) mit einer Lade-AuswurfKammer (13) verbunden ist.

## Revendications

1. Appareil (10) de fabrication d'une cellule solaire couche mince comprenant :
une chambre (11) de formation de film, qui est mise sous vide jusqu'à une pression réduite et qui forme un film sur un substrat en utilisant un procédé CVD ;
une chambre (13) d'éjection de chargement, qui communique avec la chambre de formation de film par une première partie d'ouverturefermeture et qui peut être commutée entre la pression atmosphérique et une pression réduite ;
un premier support (21) qui maintient un substrat (W1) pré-traité ; et
un deuxième support (21A) qui maintient un substrat (W2) post-traité, le premier support (21) et le deuxième support (21A) maintenant les substrats (W1, W2) dans une posture verticale lorsqu'une surface des substrats (W1, W2), où un film doit être formé, est parallèle à une direction de la force de gravité ;
la chambre (13) d'éjection de chargement emmagasinant simultanément une pluralité des premiers supports (21) et une pluralité des deuxièmes supports (21A) dans un état dans lequel la pression à l'intérieur de la chambre (13) d'éjection de chargement est réduite ;
les premiers supports (21) et les deuxièmes supports (21A) sont disposés en alternance en parallèle dans la chambre (13) d'éjection de chargement ;
les premiers supports (21) et les deuxièmes supports (21A) sont mobiles dans une direction sensiblement perpendiculaire à une direction de déplacement, en direction de la chambre (11) de formation de film au sein de la chambre (13) d'éjection de chargement.

2. Appareil (10) de fabrication d'une cellule solaire couche mince suivant la revendication 1, dans lequel le premier support (21) et le deuxième support (21A) maintiennent une pluralité des substrats (W1, W2), de sorte que les substrats (W1, W2) soient parallèles l'un à l'autre et se fassent face.

3. Appareil (10) de fabrication d'une cellule solaire couche mince suivant la revendication 1, dans lequel la chambre (13) d'éjection de chargement a un mécanisme (38) de transfert de supports, qui transfère collectivement une pluralité des deuxièmes supports (21A) à la chambre (13) d'éjection de chargement, à partir de la chambre (11) de formation de film.

4. Appareil (10) de fabrication d'une cellule solaire couche mince suivant la revendication 3, dans lequel le mécanisme (38) de transfert de supports transfère collectivement une pluralité des premiers supports (21) à la chambre (11) de formation de film, à partir de la chambre (13) d'éjection de chargement.

5. Appareil (10) de fabrication d'une cellule solaire couche mince suivant la revendication 1, comprenant en outre une pluralité de modules de traitement, dans lesquels une chambre (11) de formation de film est reliée à une chambre (13) d'éjection de chargement, la pluralité de modules de traitement étant montée en parallèle.

6. Appareil (10) de fabrication d'une cellule solaire couche mince suivant la revendication 1, dans lequel une pluralité des chambres (11) de formation de film est reliée à une chambre (13) d'éjection de chargement.
